# EUROPEAN PATENT SPECIFICATION

(11) **EP 1 137 022 B1**
(45) Date of publication and mention of the grant of the patent: **13.05.2009**
(21) Application number: 01107183.4
(22) Date of filing: 22.03.2001
(51) Int. Cl.: H01G 9/20

(54) **Dye-sensitized semiconductor particles and photoelectric conversion device**
Farbstoffsensibilisierte Halbleiterteilchen und photoelektrische Zelle
Particules à semi-conducteur sensibilisés par des chromophores et cellule photoélectrique

(30) Priority: 24.03.2000 JP 2000084511
(43) Date of publication of application: 26.09.2001
(73) Proprietor: FUJIFILM Corporation, Minato-ku Tokyo (JP)
(72) Inventor: Miyasaka, Tsutomu, Minami Ashigara-shi, Kanagawa (JP)
(74) Representative: Grünecker, Kinkeldey, Stockmair & Schwanhäusser Anwaltssozietät

(56) References cited:
- EP-A- 0 718 288
- EP-A- 0 973 181
- EP-A- 0 980 082
- EP-A- 0 986 080
- JP-A- 58 007 465

## Description

### FIELD OF THE INVENTION

This invention relates to dye-sensitized semiconductor particles, a photoelectric conversion device using the dye-sensitized semiconductor particles as an electrode, and a photocell having the photoelectric conversion device.

### BACKGROUND OF THE INVENTION

The foundations of dye-sensitized semiconductors as an electrochemical means for light energy conversion were laid in the 1970's (see H. Gerischer, Photochem. Photobiol., vol. 16, pp. 243-260 (1972)) and developed into application of a dye-sensitized thin film to an electrode (see T. Miyasaka, et al., Nature, vol. 277, pp. 638-640 (1979) and T. Miyasaka, et al., Hyomen, vol. 19, pp. 532-541 (1981)). Use of an aggregate of fine semiconductor particles having a large surface area available for dye adsorption has been proposed to bring about considerably improved light capturing efficiency, which has made it feasible to apply a dye-sensitized semiconductor to a wet type solar cell. In particular, a wet type solar cell having a porous film of dye-sensitized titanium oxide semiconductor particles as a work electrode has been expected to surpass an amorphous silicon solar cell in solar energy conversion efficiency and cost. These fundamental techniques are disclosed in Nature, vol. 353, pp. 737-740 (1991), U.S. Patents 4,927,721 and 5,350,644, JP-A-5-504023, etc. In order to further increase the solar energy conversion efficiency of wet type solar cells, it is important to improve photocurrent quantum efficiency (or photocurrent density Jsc) and open circuit photoelectromotive force (Voc). As an approach to this problem from the aspect of a semiconductor material, J. Phys. Chem. B, vol. 103, pp. 9238-9332 (1999) reports the Voc increasing effect of strontium titanate having a high energy level, but an increase in Voc is accompanied by a decrease in Jsc, ultimately failing to improve the conversion efficiency. From the aspect of a dye material, Chem. Commun., pp. 1705-1706 (1997) reports that a black ruthenium complex dye having its absorption wavelength range extended to 920 nm can be used in the presence of an additive (chenodeoxycholic acid) to raise utilization of light and thereby to improve Jsc. However, this technique involves a reduction in Voc, resulting in a failure to improve the efficiency.

JP-A-58-7465 describes the production of paint that changes its colour with humidity based on a fine powder of titanium oxide, ammonium molybdate, 1-amino-2-hydroxynaphthalene-4-sulfonic acid and a dye. EP 0 718 288 and EP 0 973 181 describe dye sensitized solar cells comprising electrolytes having sulfonic acid derivatives.

Thus one of the problems associated with wet type photocells lies in that a photocurrent density Jsc, which reflects the quantum efficiency in photoelectric conversion, and an open circuit voltage Voc, which reflects acquisition of energy of electron-hole charge separation, conflict with each other and are difficult to improve simultaneously.

### SUMMARY OF THE INVENTION

An object of the present invention is to provide a dye-sensitized photoelectric conversion device and a photocell having an improved energy conversion efficiency, especially an open circuit photoelectromotive force.

The object of the present invention is accomplished by:
(1) Semiconductor particles as defined in claim 1.
(2) The semiconductor particles of (1) above, wherein the dye is adsorbed by using a solution containing the anionic organic sulfonic acid derivative and the dye.
(3) The semiconductor particles of (1) or (2) above, wherein dye adsorption is carried out by first allowing the anionic organic sulfonic acid derivative to be adsorbed by semiconductor particles and then allowing the dye to be adsorbed thereby.
(4) The semiconductor particles of (1) above, wherein M⁺ represents an alkali metal ion.
(5) The semiconductor particles according to any one of (1) to (7) above, wherein the dye is at least one dye selected from organic metal complex dyes, phthalocyanine dyes, porphyrin dyes, and polymethine dyes.
(6) The semiconductor particles according to any one of (1) to (8) above, wherein the dye is an organic metal complex dye.
(7) A photoelectric conversion device comprising an electrode having the semiconductor particles according to (1) above, a charge transporting layer, and a counter electrode.
(8) The photoelectric conversion device of (7) above, wherein the charge transporting layer comprises a molten salt electrolyte.
(9) The photoelectric conversion device of (7) or (8) above, wherein the charge transporting layer comprises a room temperature molten salt which mainly comprises an imidazolium salt and contains no volatile components.
(10) A photocell comprising the photoelectric conversion device of (7), (8) or (9) above.

### BRIEF DESCRIPTION OF THE DRAWINGS

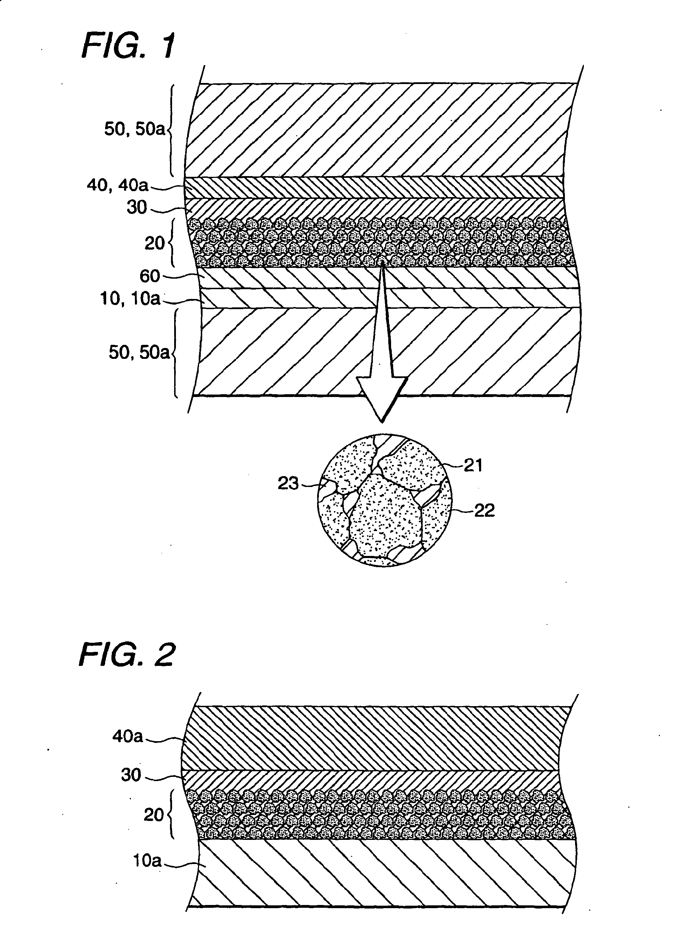

Figs. 1 through 9 are partial cross-sections illustrating preferred structures of the photoelectric conversion devices according to the present invention.

### DETAILED DESCRIPTION OF THE INVENTION

### [I] Photoelectric conversion device

The dye-sensitized semiconductor which constitutes a photosensitive layer of a photoelectric conversion device according to the invention is a semiconductor electrode having a dye adsorbed on its surface which induces electric conduction in one direction when the dye is excited by light. A dye-sensitized semiconductor electrode is exemplified by one making use of an electrochemical interface between a semiconductor electrode and an electrolytic solution. The present invention in which an ion-conductive electrolyte is used as a charge transporting layer belongs to this type. A photoelectric system having such a dye-sensitized semiconductor is characterized as a kind of photo-electrochemical cells.

A dye-sensitized n-type semiconductor serves as a photoanode, and a dye-sensitized p-type one serves as a photocathode, to produce a photocurrent (an anode photocurrent or a cathode photocurrent) flowing in a controlled direction. Light incident on a photosensitive layer comprising a photoanode excites the dye adsorbed on the semiconductor. The excited dye has high energy electrons, which are handed over to the conduction band of the n-type semiconductor particles and migrate from the semiconductor surface through bulk diffusion to reach an electrically-conductive substrate (or electrically-conductive layer) that supports the semiconductor. After the electron implantation, the dye molecules become oxidate radicals having electrons missing but are regenerated quickly by electronic reduction with an electron donor (or an ionic reducing agent in an electrolytic solution) of a charge transporting material adjoining the dye. The electrons accepted by the electrically-conductive substrate pass through an external circuit and returns to the counter electrode. The electric current thus generated in light excitation is observed in the external circuit as a photocurrent. In the case of a photocathode comprising a dye-sensitized p-type semiconductor, the excited dye hands over the excited electrons to an electron acceptor of the charge transporting layer, while the oxidate, i.e., positive holes of the dye are implanted to the valence band of the p-type semiconductor and migrate through bulk diffusion. As a result, a photocurrent flowing in a direction opposite to the one observed in the case of the photoanode is observed in the external circuit.

The photoelectric conversion device according to the present invention preferably comprises, as shown in Fig. 1, an electrically-conductive layer 10, an undercoat 60, a photosensitive layer 20, a charge transporting layer 30, and a counter electrode electrically-conductive layer 40 in this order, in which the photosensitive layer 20 is made up of semiconductor particles 21 which are sensitized with a dye 22 and a charge transporting material 23 which has penetrated into the gaps among the semiconductor particles 21. The charge transporting material 23 is the same as the one making up the charge transporting layer 30. A supporting base 50 can be provided on the electrically-conductive layer 10 and/or the counter electrode electrically-conductive layer 40 to strengthen the photoelectric conversion device. The combination of the electrically-conductive layer 10 and a base 50 that can be provided if desired will hereinafter be referred to as "an electrically-conductive substrate", and the combination of the counter electrode electrically-conductive layer 40 and a base 50 that can be provided if desired will hereinafter be referred to as a "counter electrode". The photoelectric conversion device connected to an external circuit to do work is a photocell. In Fig. 1, the conducive layer 10, the counter electrode electrically-conductive layer 40, and the base(s) 50 may be a transparent electrically-conductive layer 10a, a transparent counter electrode electrically-conductive layer 40a, and transparent base(s) 50a, respectively.

Where an n-type semiconductor electrode is used in the photoelectric conversion device shown in Fig. 1, light having entered the photosensitive layer 20 comprising the dye 22-sensitized semiconductor particles 21 excites the dye 22, etc. The excited electrons of the dye 22, etc. are handed over to the semiconductor particles 21 and diffused to reach the electrically-conductive layer 10. In this situation, the molecules of the dye 22, etc. are in an oxidized state. In a photocell, the electrons in the electrically-conductive layer 10 work in the external circuit and return to the oxidized dye 22, etc. through the counter electrode electrically-conductive layer 40 and the charge transporting layer 30, thereby regenerating the dye 22. The photosensitive layer 20 acts as a negative electrode of the cell. The components constituting the individual layers may be diffused and mixed mutually at their boundaries, for example, the boundary between the electrically-conductive layer 10 and the photosensitive layer 20, the boundary between the photosensitive layer 20 and the charge transporting layer 30, and the boundary between the charge transporting layer 30 and the counter electrode electrically-conductive layer 40.

### (A) Electrically-conductive substrate

The electrically-conductive substrate is (1) a single electrically-conductive layer or (2) a combination of an electrically-conductive layer and a base. As long as the electrically-conductive layer has sufficient strength and tight sealing properties, the base is not always necessary.

In the case (1), a material having sufficient strength and electrical conductivity, such as metal, is used as the electrically-conductive layer.

In the case (2), a base having an electrically-conductive layer containing a conducting agent on the photosensitive layer side is used. Preferred conducting agents include metals (e.g., platinum, gold, silver, copper, aluminum, rhodium, and indium), carbon, and electrically conductive metal oxides (e.g., indium tin oxide and Fluorine-doped tin oxide). The electrically-conductive layer preferably has a thickness of about 0.02 to 10 µm.

The electrically-conductive substrate preferably has as low a surface resistivity as possible. A desirable surface resistivity is 100 Ω/square or smaller, particularly 40 Ω/square or smaller. While not limiting, the practical minimal surface resistivity is about 0.1 Ω/square.

Where light is incident upon the electrically-conductive substrate side of the photoelectric conversion device, it is preferred that the electrically-conductive substrate be substantially transparent to light. The term "substantially transparent" is intended to mean that the light transmission is at least 10%, preferably 50% or more, still preferably 70% or more.

A preferred transparent electrically-conductive substrate is a transparent glass or plastic base having formed thereon a transparent electrically-conductive layer comprising an electrically-conductive metal oxide by coating or vacuum deposition or a like technique. In particular, electrically-conductive glass obtained by depositing Fluorine-doped tin dioxide on inexpensive soda-lime float glass is preferred. For the manufacture of inexpensive flexible photoelectric conversion devices or solar cells, a transparent polymer film having the above-described electrically-conductive layer is convenient. Useful transparent polymers include tetraacetylcellulose (TAC), polyethylene terephthalate (PET), polyethylene naphthalate (PEN), syndiotactic polystyrene (SPS), polyphenylene sulfide (PPS), polycarbonate (PC), polyacrylate (PAr), polysulfone (PSF), polyester sulfone (PES), polyether-imide (PEI), cyclic polyolefins, and brominated phenoxy resins. To secure sufficient transparency, the amount of the electrically-conductive metal oxide is preferably 0.01 to 100 g per m² of the glass or plastic base.

In order to decrease the resistance of the transparent electrically-conductive substrate, it is preferred to provide metal leads, which are preferably made of aluminum, copper, silver, gold, platinum, nickel, etc., with an aluminum lead or a silver lead being particularly preferred. The metal lead is preferably formed on the transparent base by vacuum evaporation, sputtering or a like deposition technique, on which a transparent electrically-conductive layer of Fluorine-doped tin oxide or ITO is provided. It is also preferred that the transparent electrically-conductive layer be provided on the transparent base, on which the metal lead can be formed. Reduction in incident light quantity due to the metal leads is preferably within 10%, still preferably 1 to 5%.

### (B) Photosensitive Layer

### (1) Semiconductor material

In the photosensitive layer comprising a dye-sensitized semiconductor, the semiconductor induces electric conduction when excited with light having a wavelength within its inherent light absorption wavelength region. It has a valence band and a conduction band as energy bands and generates electrons in the conduction band and positive holes in the valence band when excited with light having a wavelength corresponding to the band gap. In an n-type semiconductor the conduction band electrons act as a carrier to develop electric conduction. In a p-type semiconductor the positive holes in the valence band do. Preferred semiconductors are those having a carrier (electrons or positive holes) concentration of 10¹⁴ to 10²⁰/cm³. The mechanism of dye sensitization in such semiconductor electrodes pertaining to the present invention are described in detail in K. Honda and A. Fujishima, Kagaku Sosetu, No. 7, p. 77 (1976) and T. Watanabe, T. Takizawa, and K. Honda, Shokubai, No. 20, p. 370 (1978).

n-Type semiconductors are preferred to p-type ones in the present invention. Useful n-type semiconductors include element semiconductors, e.g., Si or Ge, and compound semiconductors, such as III-V element-containing compound semiconductors, metal chalcogenides (e.g., oxides, sulfides, and selenides), and perovskite semiconductors.

The metal chalcogenides preferably include an oxide of titanium, tin, zinc, iron, tungsten, zirconium, hafnium, strontium, indium, cerium, yttrium, lanthanum, vanadium, niobium or tantalum; a sulfide of cadmium, zinc, lead, silver, antimony or bismuth; a selenide of cadmium or lead; and cadmium telluride. The perovskite semiconductors include strontium titanate, calcium titanate, sodium titanate, barium titanate, and potassium niobate. Other compound semiconductors include a phosphide of zinc, gallium, indium or cadmium, gallium arsenide, copper indium selenide, and copper indium sulfide.

Examples of preferred semiconductors are Si, TiO₂, SnO₂, Fe₂O₃, WO₃, ZnO, Nb₂O₅, TiSrO₃, CdS, ZnS, PbS, Bi₂S₃, CdSe, CdTe, GaP, InP, GaAs, CuInS₂, and CuInSe₂. Still preferred are TiO₂, ZnO, SnO₂, Fe₂O₃, WO₃, Nb₂O₅, TiSrO₃, CdS, PbS, CdSe, InP, GaAs, CuInS₂, and CuInSe₂. TiO₂, ZnO, SnO₂, WO₃, TiSrO₃, and Nb₂O₅ are particularly preferred. TiO₂ is the most preferred.

p-Type semiconductors which can preferably be used include Cu₂O, CuI, GaP, GaAs, NiO, CoO, FeO, Cr₂O₃, SnS, Bi₂O₃, MoO₂, Si, and Ge.

The semiconductor may be a single crystal or polycrystalline. A polycrystalline semiconductor is preferred from the standpoint of production cost, supply of raw materials, and an energy payback time. A porous film comprising semiconductor particles is still preferred.

The semiconductor particles, which generally have a particle size on the order of nanometers to micronmeters, preferably have an average primary particle size of 5 to 200 nm, particularly 8 to 100 nm, in terms of a projected area diameter. The semiconductor particles in a dispersed state (secondary particles) preferably have an average particle size of 0.01 to 100 µm.

Semiconductor particles of two or more kinds having different size distributions can be used as a mixture. In this case, the average size of smaller particles is preferably 5 nm or smaller. For the purpose of scattering incident light to improve the rate of capturing light, large semiconductor particles about 300 nm in size may be used in combination.

The particulate semiconductor is preferably prepared by a sol-gel method described, e.g., in Sumio Sakubana, Sol-gel-hono kagaku, Agune Shofusha (1988) and Gijutsu Joho Kyokai, Sol-gel-ho niyoru hakumaku coating gijutsu (1995), and a gel-sol method described in Tadao Sugimoto, Materia, vol. 35, No. 9, pp. 1012-1018, "Shin goseiho gel-sol-ho niyoru tanbunsan ryushino goseito size keitai seigyo" (1996). The method for preparing an oxide developed by Degussa AG which comprises pyrogenically hydrolyzing a metal chloride in an oxyhydrogen flame is also preferred.

For preparation of titanium oxide particles, a sulfuric acid method and a chlorine method described in Manabu Seino, Sanka titan busseito ohyogijutu, Gihodo (1997) are also employable for preference in addition to the above-described sol-gel method, gel-sol method and pyrogenic flame hydrolysis. The sol-gel methods described in Barbe, et al, Journal of American Ceramic Society, vol. 80, No. 12, pp. 3157-3171 (1997) and Burnside, et al., Chemical Materials, vol. 10, No. 9, pp. 2419-2425 are also preferred.

### (2) Formation of Particulate Semiconductor Layer

The particulate semiconductor layer is formed on the electrically-conductive substrate by, for example, a method comprising coating the electrically-conductive substrate with a dispersion or colloidal solution of the semiconductor particles or the aforementioned sol-gel method, and the like. Film formation in a wet system is relatively advantageous, taking into consideration suitability to large-scale production of a photoelectric conversion device, controllability of liquid physical properties, and adaptability to various electrically-conductive substrates. Film formation in a wet system is typically carried out by coating methods or printing methods.

Wet coating methods include application methods such as roll coating and dip coating, metering methods such as air knife coating or blade coating, and application methods combined with metering such as wire bar coating (JP-B-58-4589), slide hopper coating (U.S. Patents 2,681,294, 2,761,419, and 2,761,791), extrusion coating, and curtain coating. General-purpose spin coating or spraying techniques are also suitable.

The semiconductor layer does not need to be a single layer. Two or more layers different in particle size of semiconductor particles, in kind of semiconductors or in composition as for the binder or additives can be provided. In case where single operation of application is insufficient for giving a desired thickness, multilayer coating is effective. Extrusion coating or slide hopper coating is suitable for multilayer coating. Multilayer coating can be carried out simultaneously or by successively repeating the coating operation several times or more than ten times. Screen printing is also preferably applicable to successive multilayer coating.

In general, as the thickness of the particulate semiconductor layer (i.e., photosensitive layer) increases, the amount of the dye held per unit projected area increases to show an increased rate of capturing light, but the distance of diffusion of generated electrons also increases, which results in an increased loss due to recoupling of charges. Accordingly, there is a favorable thickness range for the particulate semiconductor layer, which is typically from 0.1 to 100 µm. Where the device is applied to a solar cell, a favorable thickness is 1 to 30 µm, particularly 2 to 25 µm. The coating weight of the semiconductor particles is preferably 0.5 to 400 g/m², still preferably 5 to 100 g/m².

It is preferred that the semiconductor particles applied to the electrically-conductive substrate be heated to bring them into electronic contact with each other, to improve film strength, and to improve adhesion to the substrate. A preferred heating temperature is from 40 to 700°C, particularly from 100 to 600°C. The heating time is usually from about 10 minutes to about 10 hours. Where a substrate having a low melting point or a low softening point, such as a polymer film, is used, the heating temperature should of necessity be as low as possible. The heating temperature can be lowered by using small semiconductor particles having a diameter of up to 5 nm in combination as previously noted or by conducting the heat treatment in the presence of a mineral acid.

It is preferable for the particulate semiconductor layer to have a large surface area so that it may adsorb as large an amount of a dye as possible. The surface area of the semiconductor layer is preferably such that the roughness factor, a ratio of the surface area to the projected area, is 10 or greater, particularly 100 or greater. The practical upper limit of the roughness factor is, while not limited to, about 1000.

### (3) Dye

The semiconductor particles constituting the photosensitive layer are sensitized with a dye adsorbed thereby. Any dye capable of spectrally sensitizing a semiconductor can be used. Two or more kinds of dyes are advantageously used in combination so as to broaden the wavelength region of photoelectric conversion and to increase the conversion efficiency. The dyes to be combined and their ratio can be selected in conformity with the wavelength region and the intensity distribution of a light source to be used. Of available sensitizing dyes, preferred are organic metal complex dyes, phthalocyanine dyes, porphyrin dyes, and polymethine dyes (especially merocyanine dyes) for their activity in light-excited electron transfer reaction, light resistance, and photochemical stability. *Inter alia*, metal complex dyes represented by ruthenium complex dyes are preferred.

It is preferred for the dyes to have an appropriate interlocking group for linking to the surface of the semiconductor particles. Preferred interlocking groups include -COOH, -OH, -SO₃H, a cyano group, -P(O)(OH)₂, -OP(O)(OH)₂, and chelating groups having pi conductivity, such as oxime, dioxime, hydroxyquinoline, salicylate and α-keto-enolate groups. Particularly preferred of them are -COOH, -P(O)(OH)₂, and -OP (O) (OH)₂. The interlocking group may be in the form of a salt with an alkali metal, etc. or an intramolecular salt. Where the methine chain of a polymethine dye has an acidic group as in the case where the methine chain forms a squarylium ring or a croconium ring, that moiety can serve as an interlocking group.

### (a) Organic Metal Complex Dye

The metal complex dyes preferably include ruthenium complex dyes. Useful ruthenium complex dyes are described, e.g., in U.S. Patents 4,927,721, 4,684,537, 5,084,365, 5,350,644, 5,463,057, and 5,525,440, JP-A-7-249790, JP-W-10-504521, and WO98/50393. Those represented by formula (III) are particularly preferred.

(A₁)ₚRu(B-a)(B-b)(B-c) (III)

wherein A₁ represents a ligand selected from Cl, SCN, H₂O, Br, I, CN, NCO and SeCN; p represents an integer of 0 to 3; and B-a, B-b, and B-c each represent an organic ligand selected from B-1 to B-10 shown below. 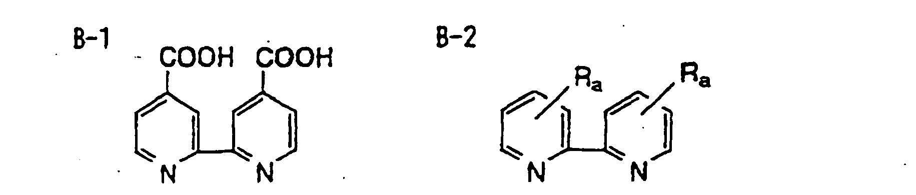 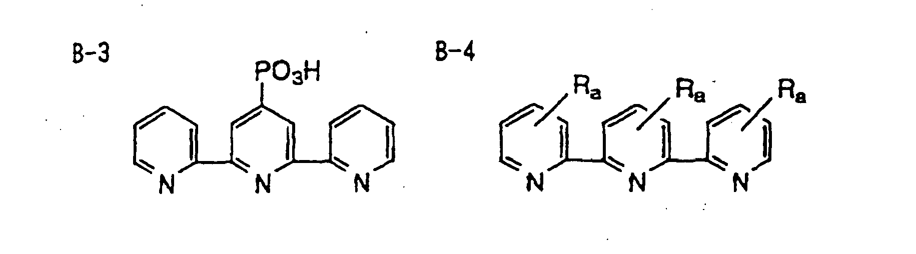 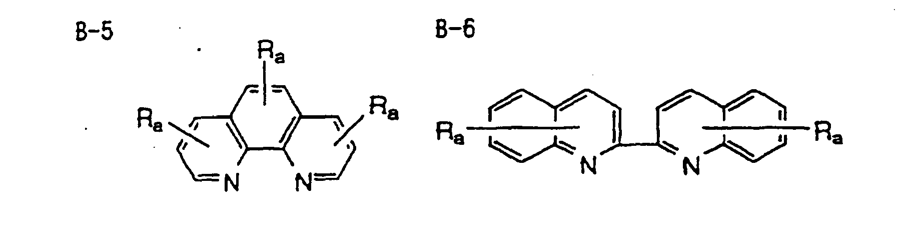 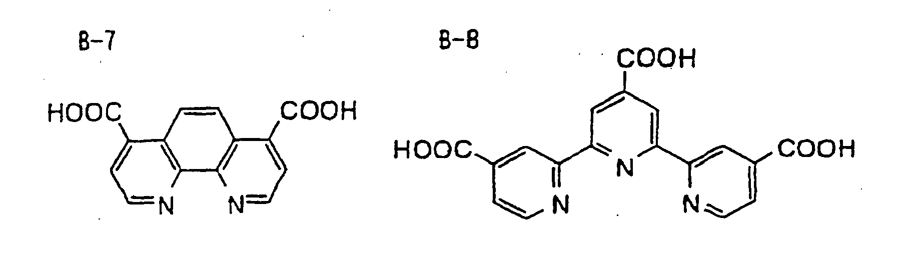 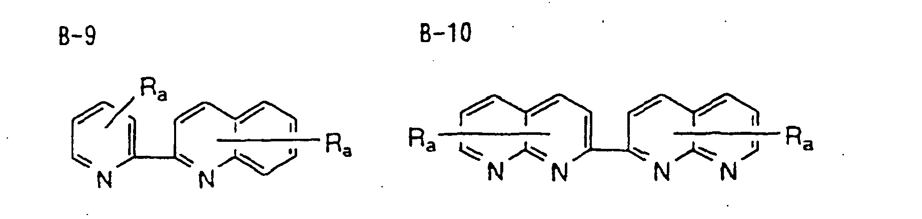 wherein Rₐ represents a hydrogen atom or a substitutent.

The substituent as Rₐ includes a halogen atom, a substituted or unsubstituted alkyl group having 1 to 12 carbon atoms, a substituted or unsubstituted aralkyl group having 7 to 12 carbon atoms, a substituted or unsubstituted aryl group having 6 to 12 carbon atoms, a carboxyl group, and a phosphoric acid group. The acid groups may be in a salt form. The alkyl group and the alkyl moiety of the aralkyl group may be either straight or branched, and the aryl group and the aryl moiety of the aralkyl group may be either monocyclic or polycyclic (condensed rings or independent rings). The organic ligands, B-a, B-b and B-c, may be the same or different. In other words, all the organic ligands may be of a kind or two kinds.

Specific but non-limiting examples of preferred ruthenium complex dyes represented by formula (III) are tabulated below.

| (A₁)ₚRu(B-a)(B-b)(B-c) | | | | | | |
|---|---|---|---|---|---|---|
| No. | A₁ | p | B-a | B-b | B-c | Rₐ |
| R-1 | SCN | 2 | B-1 | B-1 | - | - |
| R-2 | CN | 2 | B-1 | B-1 | - | - |
| R-3 | Cl | 2 | B-1 | B-1 | - | - |
| R-4 | CN | 2 | B-7 | B-7 | - | - |
| R-5 | SCN | 2 | B-7 | B-7 | - | - |
| R-6 | SCN | 2 | B-1 | B-2 | - | H |
| R-7 | SCN | 1 | B-1 | B-3 | - | - |
| R-8 | Cl | 1 | B-1 | B-4 | - | H |
| R-9 | I | 2 | B-1 | B-5 | - | H |
| R-10 | SCN | 3 | B-8 | - | - | - |
| R-11 | CN | 3 | B-8 | - | - | - |
| R-12 | SCN | 1 | B-8 | B-2 | - | H |
| R-13 | - | 0 | B-1 | B-1 | B-1 | - |

Specific examples of other preferred metal complex dyes are shown below.

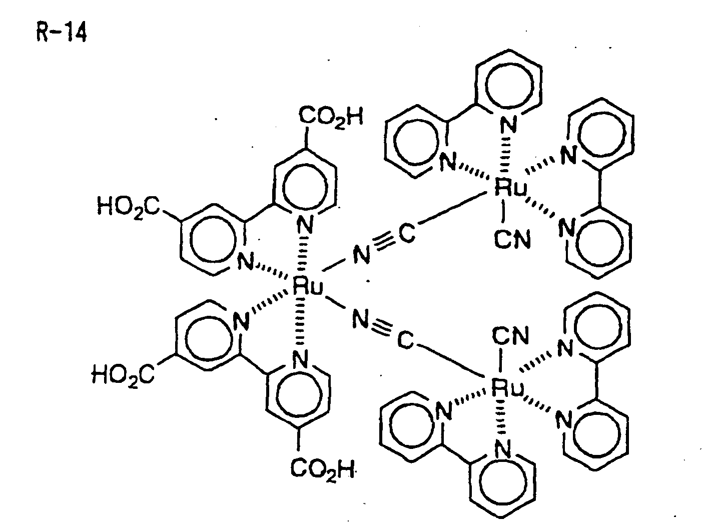

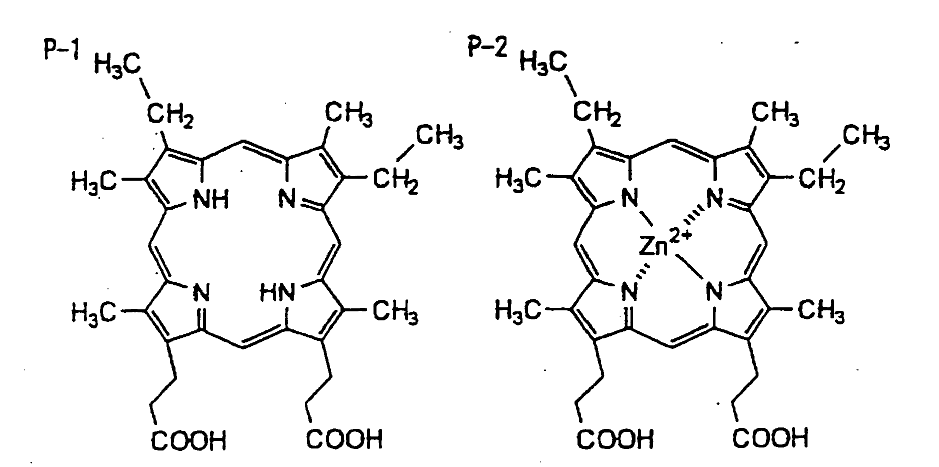

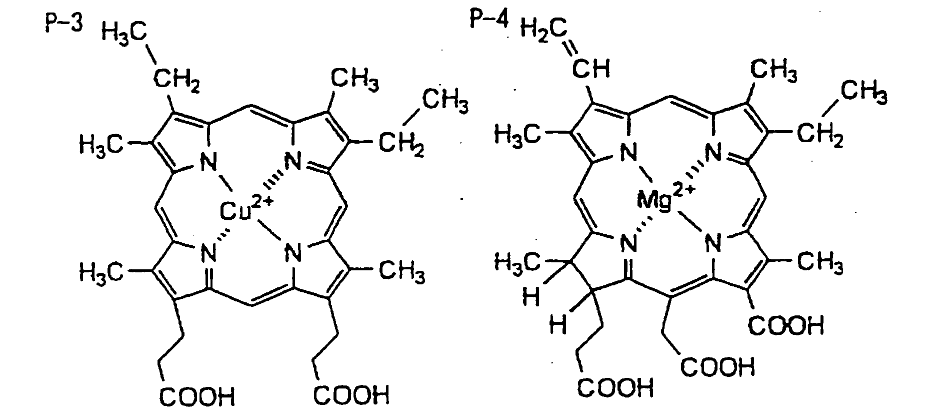

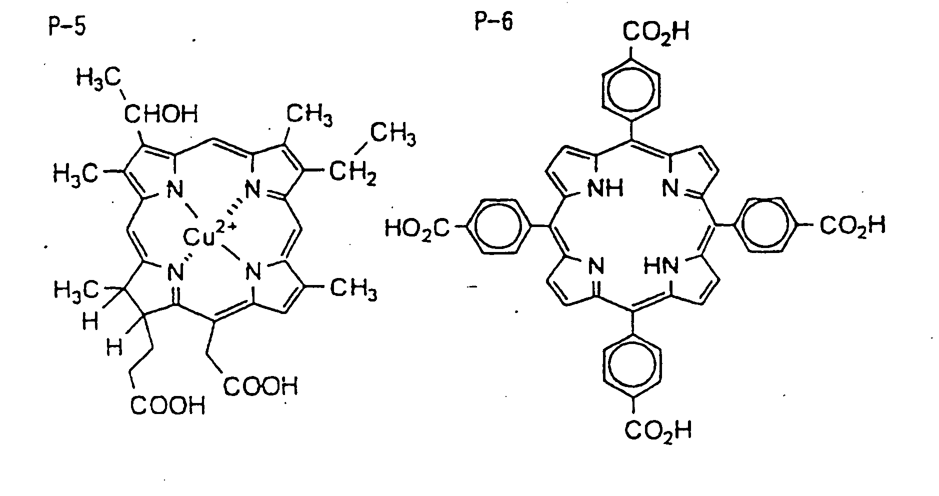

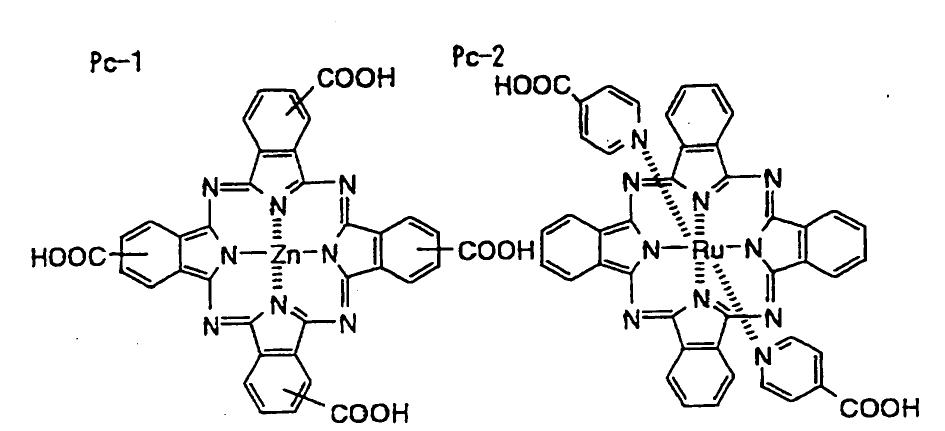

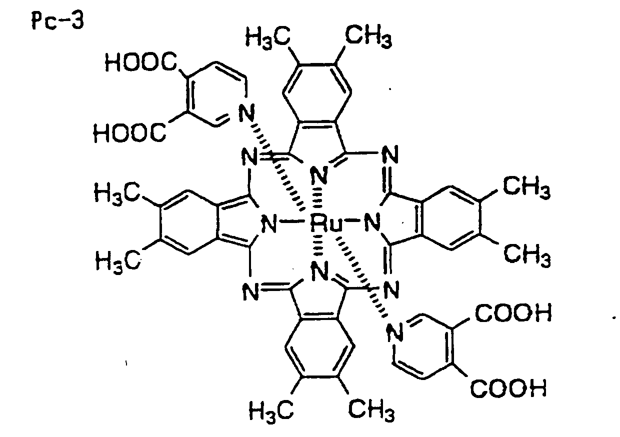

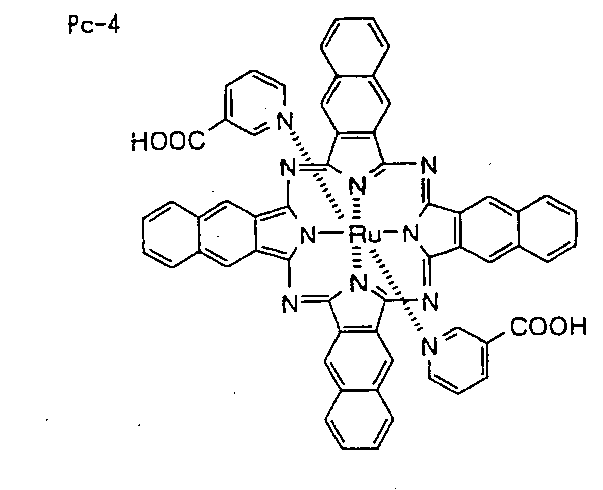

### (b) Polymethine Dye

The polymethine dyes which can be used preferably include those described in JP-A-11-35836, JP-A-11-158395, JP-A-11-163378, JP-A-11-214730, JP-A-11-214731, EP 892411, and EP 911841. These methine dyes are synthesized with reference to the teachings of F.M. Harmer, Heterocyclic Compounds-Cyanine Dyes and Related Compounds, John Wiley & Sons (1964), D.M. Sturmer, Heterocyclic Compounds-Special Topics in Heterocyclic Chemistry, ch. 18, §14, pp. 482-515, John Wiley & Sons (1977), and Rodd's Chemistry of Carbon Compounds, 2nd Ed., vol. IV, part B, ch. 15, pp. 369-422, Elsevier Science Publishing Company Inc. (1977), GB Patent 1,077,611, Ukrainskii Khimicheskii Zhurnal, vol. 40, No. 3, pp. 253-258, Dyes and Pigment, vol. 21, pp. 227-234, and references cited therein.

Specific examples of suitable polymethine dyes are shown below.

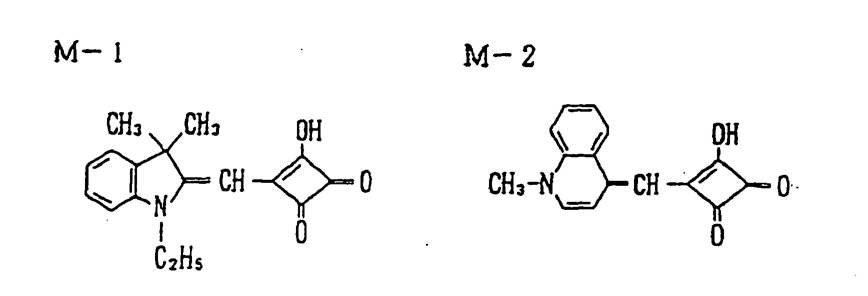

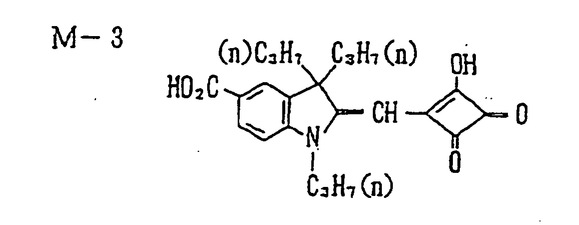

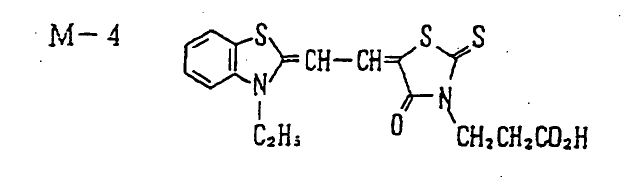

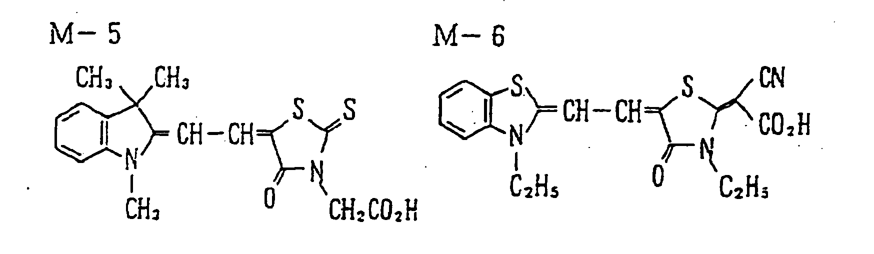

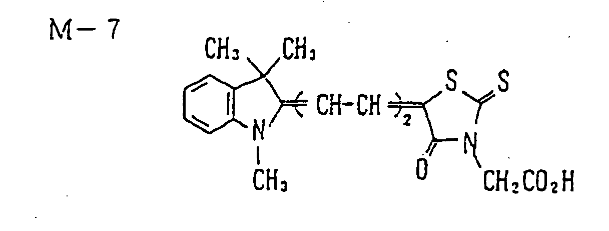

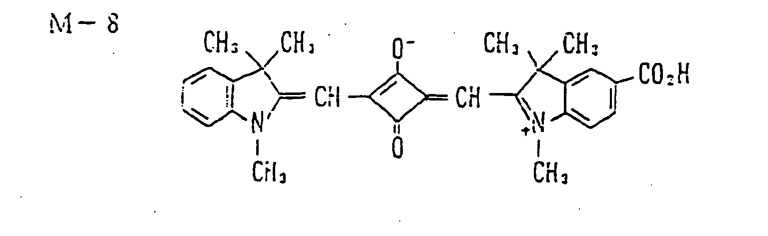

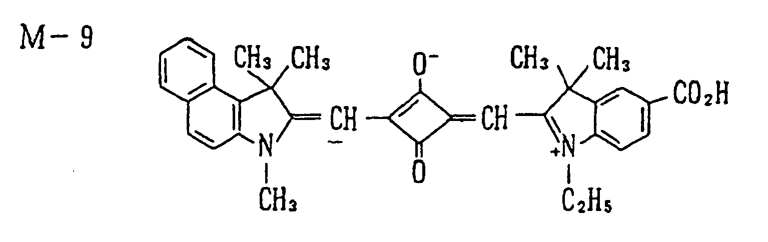

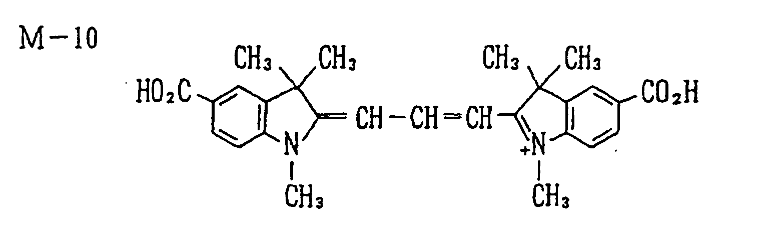

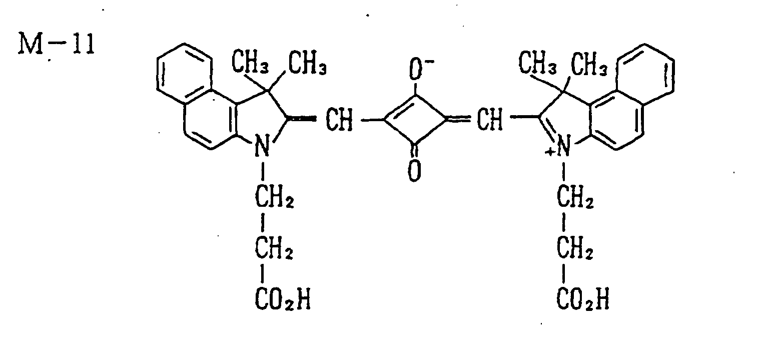

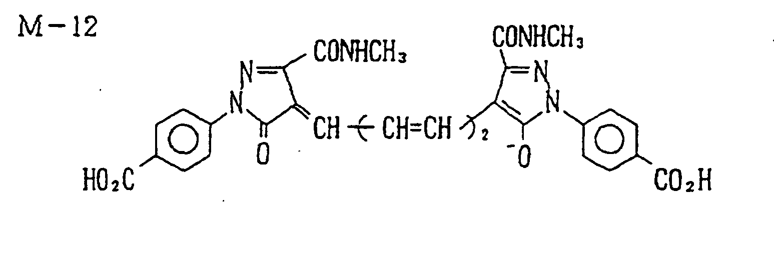

### (4) Dye Adsorption to Semiconductor Particles

Adsorption of the dye to semiconductor particles is carried out by dipping a well-dried electrode (an electrically-conductive substrate having a particulate semiconductor layer) in a dye solution, which can be embodied by immersion, dip coating, roll coating, air knife coating, etc., or coating the semiconductor layer with a dye solution, which can be embodied by wire bar coating, slide hopper coating, extrusion coating, curtain coating, spin coating, spraying, and the like. In case of immersion, the dye adsorption may be either at room temperature or under reflux as taught in JP-A-7-249790.

The solvent of the dye solution includes alcohols (e.g., methanol, ethanol, t-butanol and benzyl alcohol), nitriles (e.g., acetonitrile, propionitrile and 3-methoxypropionitrile), nitromethane, halogenated hydrocarbons (e.g., dichloromethane, dichloroethane, chloroform, and chlorobenzene), ethers (e.g., diethyl ether and tetrahydrofuran), dimethyl sulfoxide, amides (e.g., N,N-dimethylformamide and N,N-dimethylacetamide), N-methylpyrrolidone, 1,3-dimethylimidazolidinone, 3-methyloxazolidinone, esters (e.g., ethyl acetate and butyl acetate), carbonic esters (e.g., diethyl carbonate, ethylene carbonate, and propylene carbonate), ketones (e.g., acetone, 2-butanone, and cyclohexanone), hydrocarbons (e.g., hexane, petroleum ether, benzene, and toluene), and mixtures thereof.

The present invention is **characterized in that** dye adsorption to the semiconductor particles is carried out in the presence of an anionic organic sulfonic acid derivative (hereinafter simply referred to as "the sulfonic acid derivative"). In the presence of the sulfonic acid derivative, dissipation of exciting energy which is ascribed to agglomeration of dye molecules in a dye solution or on the surface of semiconductor particles can be suppressed thereby suppressing a reduction of dye sensitization efficiency, which leads to improvement on light energy conversion efficiency.

The dye adsorption in the presence of the sulfonic acid derivative is preferably conducted by using a dye solution containing the sulfonic acid derivative and bringing the solution into contact with the particulate semiconductor layer by the above-mentioned application techniques such as immersion or coating. Additionally it is also preferred that adsorption of the sulfonic acid derivative to the particulate semiconductor layer by the method of immersing the particulate semiconductor layer in a solution of the sulfonic acid derivative be followed by adsorption of a dye by the above-mentioned application techniques.

The organic sulfonic acid derivatives which can be used in the present invention preferably include those represented by formula (II) :

R₂-Ph-O-(CH₂CH₂O)ₙ-L₂-SO₃⁻M⁺ (II)

wherein R₂ represents a straight-chain or branched alkyl group; Ph represents a phenylene group; n represents an integer of 0 to 50; L₂ represents a single bond, a substituted or unsubstituted alkylene group or a substituted or unsubstituted alkyleneoxy group; and M⁺ is a cation, preferably an alkali metal ion or an ammonium ion, still preferably an Na ion or a K ion
R₂ preferably contains 1 to 20 carbon atoms. The phenylene group as Ph includes 1,2-phenylene, 1,3-phenylene, and 1,4-phenylene, with 1,4-phenylene being preferred. The phenylene group can have a substituent(s), which can be selected from those enumerated above as to Ar,
n is preferably 1 to 30, still preferably 1 to 20.
L₂ is preferably a single bond, an alkylene group having 1 to 10 carbon atoms, or an alkyleneoxy group having 1 to 10 carbon atoms, still preferably a single bond, an alkylene group having 1 to 6 carbon atoms or an alkyleneoxy group having 1 to 6 carbon atoms.

Specific examples of preferred sulfonic acid derivatives i.e. compounds S-1 to S-11 and S-20,S21 Compounds S-12 to S-19 do not form part of the prevent invention. are shown below.

| R₂-(1,4-phenylene)-O-(CH₂CH₂O)ₙ-L₂-SO₃⁻M⁺ | | | | |
|---|---|---|---|---|
| Compound No. | R₂ | n | L₂ | M |
| S-1 | t-C₈H₁₇ | 1 | - | Na |
| S-2 | C₉H₁₉ | 1 | - | Na |
| S-3 | t-C₈H₁₇ | 2 | CH₂CH₂ | Na |
| S-4 | C₉H₁₉ | 2 | CH₂CH₂ | Na |
| S-5 | t-C₈H₁₇ | 3 | CH₂CH₂O | Na |
| S-6 | C₉H₁₉ | 3 | CH₂CH₂O | Na |
| S-7 | t-C₈H₁₇ | 3 | CH₂CH₂CH₂CH₂ | Na |
| S-8 | C₉H₁₉ | 3 | CH₂CH₂CH₂CH₂ | K |
| S-9 | t-C₈H₁₇ | 10 | CH₂CH₂CH₂CH₂ | Na |
| S-10 | C₉H₁₉ | 16 | CH₂O | K |

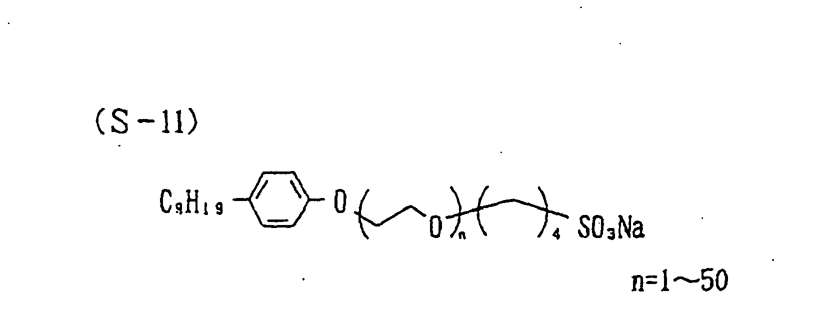

(S - 12) CnH₂ₙ₊₁-O-SO₃Na n= 8, 10, 12, 14, 16

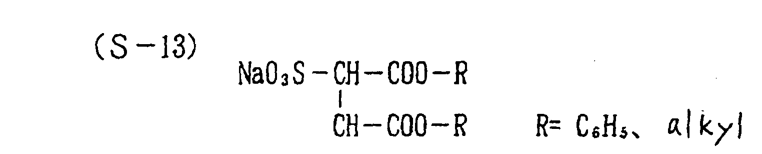

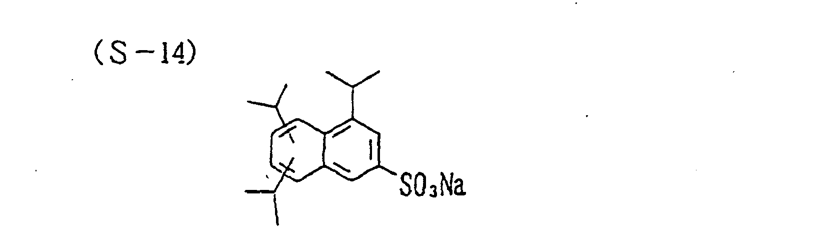

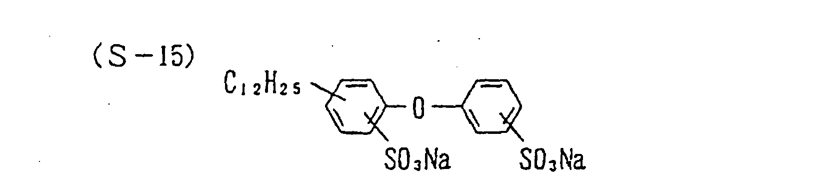

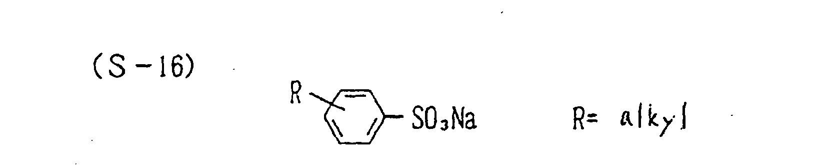

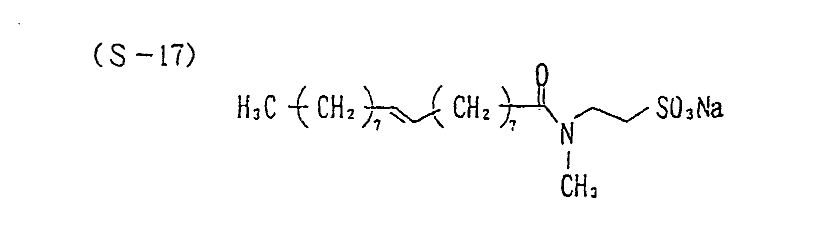

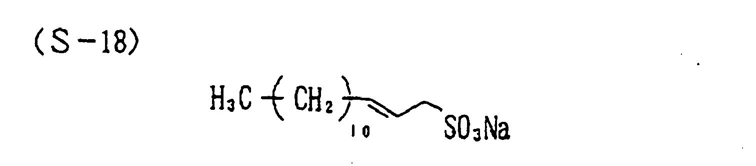

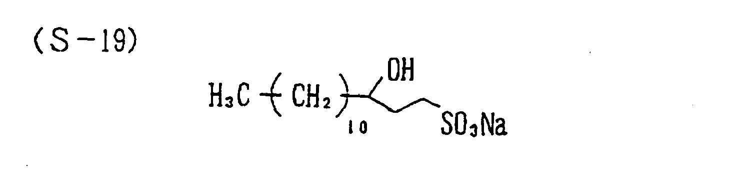

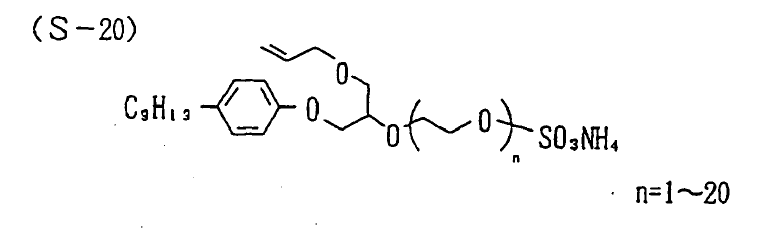

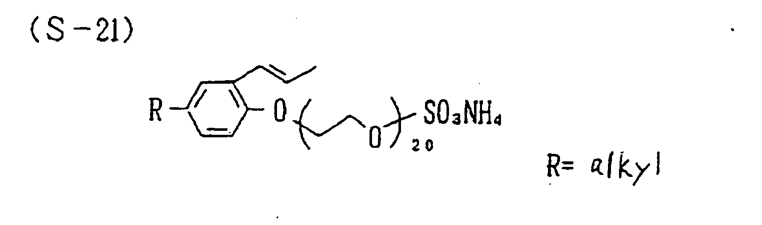

When the sulfonic acid derivative is used together with a dye in a dye solution, it is preferably added to the dye solution in an amount of 1 to 1000 mol, particularly 10 to 100 mol, per mole of the dye. When the sulfonic acid derivative is adsorbed by the semiconductor particles together with a dye, the amount of the sulfonic acid to be adsorbed is preferably 0.1 to 100 mol per mole of the dye adsorbed per unit surface area.

The total amount of the dyes to be adsorbed is preferably 0.01 to 100 mmol per unit surface area (m²) of the electrically-conductive substrate and 0.01 to 1 mmol per gram of the semiconductor particles.

If desired, a colorless compound can be adsorbed together with the dye and the sulfonic acid derivative so as to lessen the interaction among dye molecules. Carboxyl-containing steroid compounds (e.g., chenodeoxycholic acid) can be used for this purpose.

If desired, the surface of the semiconductor particles can be treated with an amine after dye adsorption so as to accelerate removal of the unadsorbed dyes. Preferred amines include pyridine, 4-t-butylpyridine, and polyvinylpyridine. The amine can be used as such where it is liquid, or as dissolved in an organic solvent.

### (C) Charge Transporting Layer

The charge transporting layer is a layer comprising a charge transporting material having a function of replenishing oxidized dyes with electrons. The charge transporting material which can be used in the invention typically includes a solution of a redox ion system in a solvent (i.e., an electrolytic solution), a gel electrolyte comprising a polymer matrix impregnated with a solution of a redox system, a molten salt electrolyte containing a redox ion system, and a solid electrolyte. In place of the charge transporting materials comprising ions, solid materials in which carrier transfer takes part in electric conduction, i.e., electron transporting materials or hole-transporting materials, can also be used. The former and the latter types of charge transporting materials can be used in combination.

### (1) Molten Salt Electrolyte

A molten salt electrolyte is preferred for securing both photoelectric efficiency and durability. Known iodine salts described, e.g., in WO 95/18456, JP-A-8-259543, and Denki Kagaku, vol. 65, No. 11, p. 923 (1997), such as pyridinium iodides, imidazolium iodides, and triazolium iodides, can be used. A room temperature molten salt electrolyte which mainly contains foregoing iodine salts and contains no volatile components can also be used.

Molten salts which can be used preferably include those represented by the following formulae (Y-a), (Y-b), and (Y-c) :

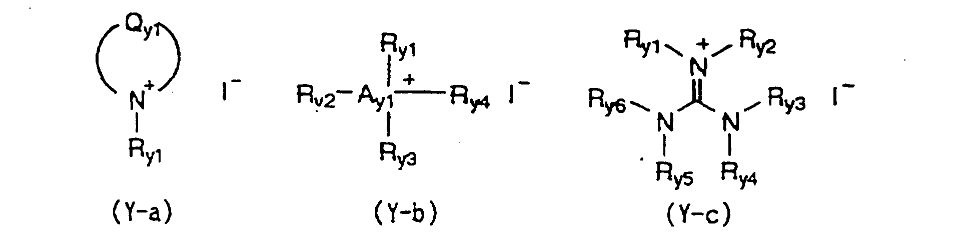

In formula (Y-a), Q_{y1} represents an atomic group forming a 5- or 6-membered aromatic cation together with the nitrogen atom. Q_{y1} is preferably made up of at least one atom selected from the group consisting of carbon, hydrogen, nitrogen, oxygen, and sulfur.

The 5-membered ring completed by Q_{y1} is preferably an oxazole ring, a thiazole ring, an imidazole ring, a pyrazole ring, an isoxazole ring, a thiadiazole ring, an oxadiazole ring or a triazole ring, still preferably an oxazole ring, a thiazole ring or an imidazole ring, particularly preferably an oxazole ring or an imidazole ring. The 6-membered ring completed by Q_{y1} is preferably a pyridine ring, a pyrimidine ring, a pyridazine ring, a pyrazine ring or a triazine ring, with a pyridine ring being still preferred.

In formula (Y-b), A_{y1} represents a nitrogen atom or a phosphorus atom.

In formulae (Y-a), (Y-b) and (Y-c), R_{y1}, R_{y2}, R_{y3}, R_{y4}, R_{y5}, and R_{y6} each independently represent a substituted or unsubstituted alkyl group (preferably a straight-chain, branched or cyclic alkyl group having 1 to 24 carbon atoms, such as methyl, ethyl, propyl, isopropyl, pentyl, hexyl, octyl, 2-ethylhexyl, t-octyl, decyl, dodecyl, tetradecyl, 2-hexyldecyl, octadecyl, cyclohexyl, or cyclopentyl) or a substituted or unsubstituted alkenyl group (preferably a straight-chain or branched alkenyl group having 2 to 24 carbon atoms, such as vinyl or allyl). R_{y1}, R_{y2}, R_{y3}, R_{y4}, R_{y5}, and R_{y6} each preferably represent an alkyl group having 2 to 18 carbon atoms or an alkenyl group having 2 to 18 carbon atoms, particularly an alkyl group having 2 to 6 carbon atoms.

In formula (Y-b), two or more of R_{y1}, R_{y2}, R_{y3}, and R_{y4} may be taken together to form a non-aromatic ring containing A_{y1}. In formula (Y-c), two or more of R_{y1}, R_{y2}, R_{y3}, R_{y4}, R_{y5}, and R_{y6} may be taken together to form a cyclic structure.

In formulae (Y-a), (Y-b), and (Y-c), Q_{y1}, R_{y1}, R_{y2}, R_{y3}, R_{y4}, R_{y5}, and R_{y6} may have a substituent(s). Suitable substituents include a halogen atom (e.g., F, Cl, Br or I), a cyano group, an alkoxy group (e.g., methoxy or ethoxy), an aryloxy group (e.g., phenoxy), an alkylthio group (e.g., methylthio or ethylthio), an alkoxycarbonyl group (ethoxycarbonyl), a carbonic ester group (e.g., ethoxycarbonyloxy), an acyl group (e.g., acetyl, propionyl or benzoyl), a sulfonyl group (e.g., methanesulfonyl or benzenesulfonyl), an acyloxy group (e.g., acetoxy or benzoyloxy), a sulfonyloxy group (e.g., methanesulfonyloxy or toluenesulfonyloxy), a phosphonyl group (e.g., diethylphosphonyl), an amido group (e.g., acetylamino or benzoylamino), a carbamoyl group (e.g., N,N-dimethylcarbamoyl), an alkyl group (methyl, ethyl, propyl, isopropyl, cyclopropyl, butyl, 2-carboxyethyl or benzyl), an aryl group (e.g., phenyl or toluyl), a heterocyclic group (e.g., pyridyl, imidazolyl or furanyl), and an alkenyl group (e.g., vinyl or 1-propenyl).

The compounds represented by formulae (Y-a), (Y-b) or (Y-c) may form dimers or polymers at Q_{y1}, R_{y1}, R_{y2}, R_{y3}, R_{y4}, R_{y5} or R_{y6}.

These molten salts may be used either individually or as a mixture of two or more thereof or in combination with other molten salts having the above-described structures in which the iodide anion is replaced with other anions, preferably other halide ions (e.g., Cl⁻ and Br⁻), NCS⁻, BF₄⁻, PF₆⁻, ClO₄⁻, (CF₃SO₂)₂N⁻, (CF₃CF₂SO₂)₂N⁻, CF₃SO₃⁻, CF₃COO⁻, Ph₄B⁻, and (CF₃SO₂)₃C⁻, particularly (CF₃SO₂)₂N⁻ or BF₄⁻. Other iodine salts, such as LiI, can also be added.

Specific examples of molten salts which are preferably used in the invention are shown below for illustrative purposes only but not for limitation.

| | |
|---|---|
| 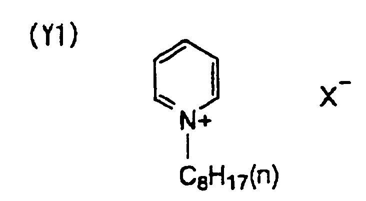 | Y1-1 X=I |
| | Y1-2 X=BF₄ |
| | Y1-3 X=N(SO₂CF₃)₂ |
| | Y1-4 X=PF₆ |
| 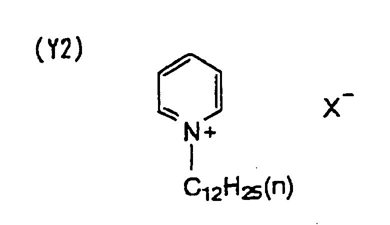 | Y2-1 X=I |
| | Y2-2 X=BF₄. |
| | Y2-3 X=N(SO₂CF₃)₂ |
| | Y2-4 X=PF₆ |
| 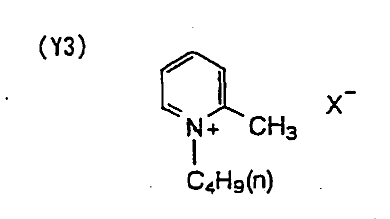 | Y3-1 X=I |
| | Y3-2 X=BF₄ |
| | Y3-3 X=N(SO₂CF₃)₂ |
| 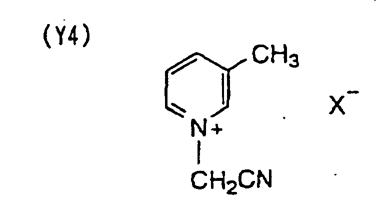 | Y4-1 X=I |
| | Y4-2 X=BF₄ |
| | Y4-3 X=N(SO₂CF₃)₂ |
| 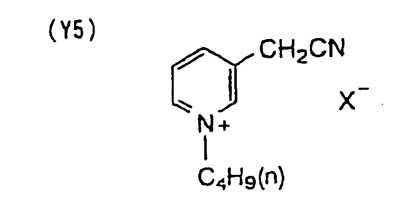 | Y5-1 X=I |
| | Y5-2 X=BF₄ |
| | Y5-3 X=N(SO₂CF₃)₂ |
| 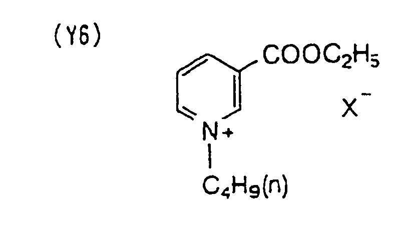 | Y6-1 X=I |
| | Y6-2 X=BF₄ |
| | Y6-3 X=N(SO₂CF₃)₂ |
| 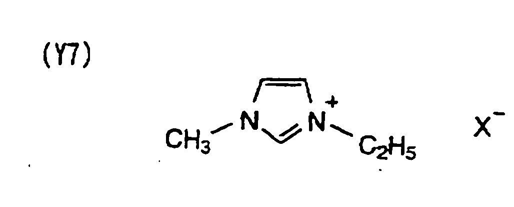 | Y7-1 X=I |
| | Y7-2 X=BF₄ |
| | Y7-3 X=N(SO₂CF₃)₂ |
| | Y7-4 X=Br |
| 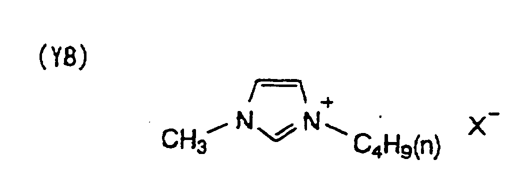 | YB-1 X=I |
| | Y8-2 X=BF₄ |
| | Y8-3 X=N(SO₂CF₃)₂ |
| 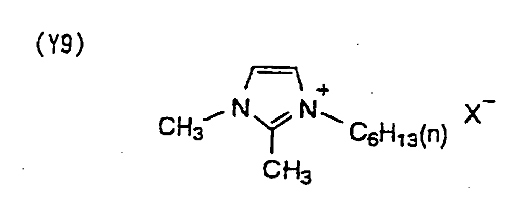 | Y9-1 X=I |
| | Y9-2 X=BF₄ |
| | Y9-3 X=N(SO₂CF₃)₂ |
| 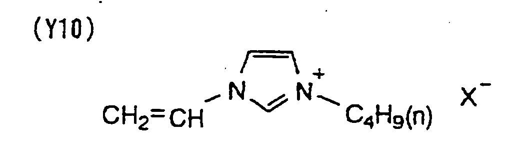 | Y10-1 X=1 |
| | Y10-2 X=BF₄ |
| | Y10-3 X=N(SO₂CF₃)₂ |
| 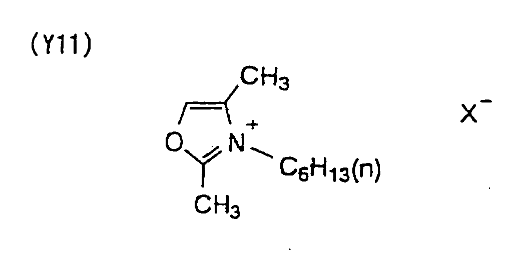 | Y11-1 X=I |
| | Y11-2 X=BF₄ |
| | Y11-3 X=N(SO₂CF₃)₂ |
| 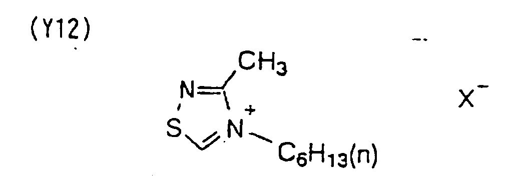 | Y12-1 X=I |
| | Y12-2 X=BF₄ |
| | Y12-3 X=N(SO₂CF₃)₂ |
| 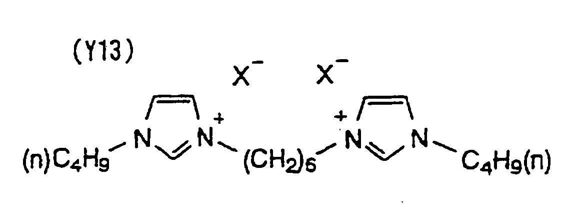 | Y13-1 X=I |
| | Y13-2 X=BF₄ |
| | Y13-3 X=N(SO₂CF₃)₂ |
| 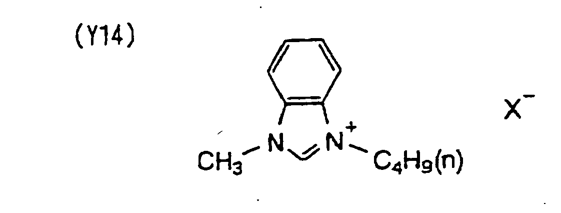 | Y14-1 X=I |
| | Y14-2 X=BF₄ |
| | Y14-3 X=N(SO₂CF₃)₂ |
| 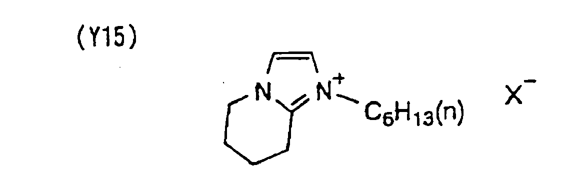 | Y15-1 X=I |
| | Y15-2 X=BF₄ |
| | Y15-3 X=N(SO₂CF₃)₂ |
| 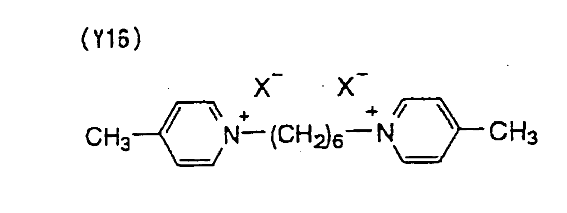 | Y16-1 X=I |
| | Y16-2 X=BF₄ |
| | Y16-3 X=N(SO₂CF₃)₂ |
| 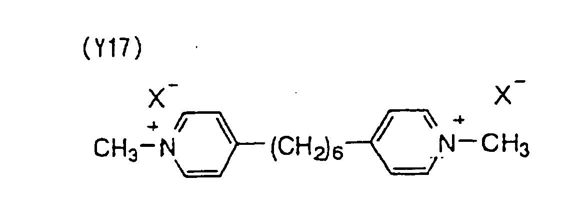 | Y17-1 X=I |
| | Y17-2 X=BF₄ |
| | Y17-3 X=N(SO₂CF₃)₂ |
| 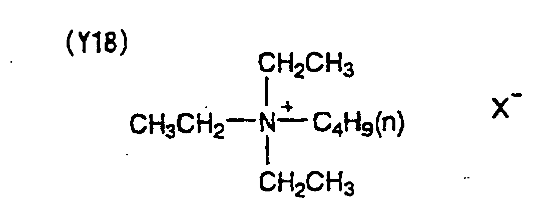 | Y18-1 X=I |
| | Y18-2 X=BF₄ |
| | Y18-3 X=N(SO₂CF₃)₂ |
| | Y18-4 X=PF₆ |
| 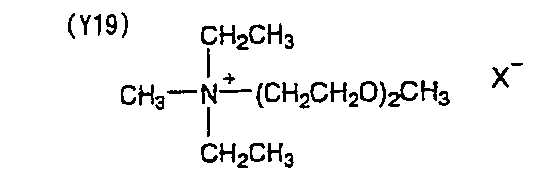 | Y19-1 X=I |
| | Y19-2 X=BF₄ |
| | Y19-3 X=N(SO₂CF₃)₂ |
| 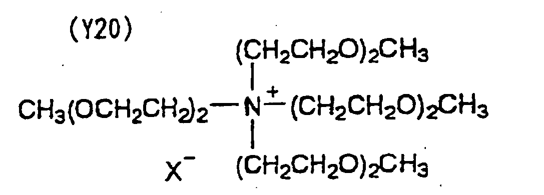 | Y20-1 X=I |
| | Y20-2 X=BF₄ |
| | Y20-3 X=N(SO₂CF₃)₂ |
| 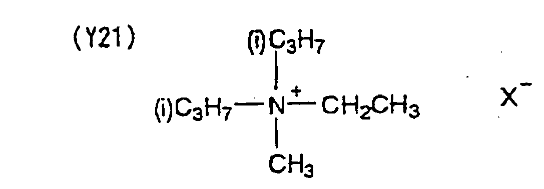 | Y21-1 X=I |
| | Y21-2 X=BF₄ |
| | Y21-3 X=N(SO₂CF₃)₂ |
| 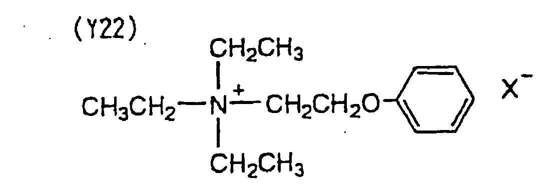 | Y22-1 X=I |
| | Y22-2 X=BF₄ |
| | Y22-3 X=N(SO₂CF₃)₂ |
| 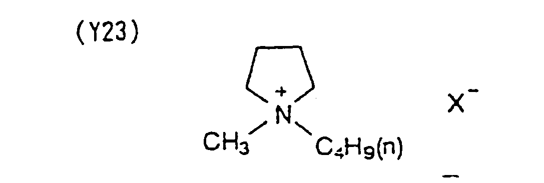 | Y23-1 X=I |
| | Y23-2 X=BF₄ |
| | Y23-3 X=N(SO₂CF₃)₂ |
| 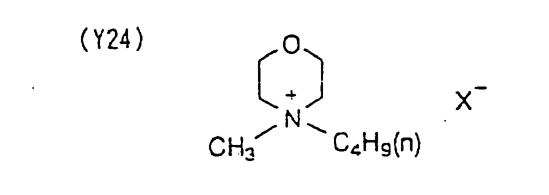 | Y24-1 X=I |
| | Y24-2 X=BF₄ |
| | Y24-3 X=N(SO₂CF₃)₂ |
| 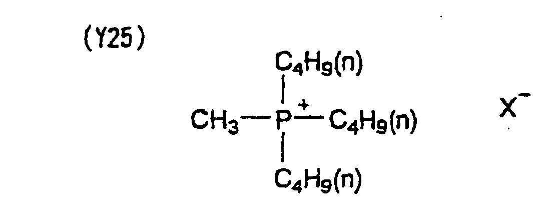 | Y25-1 X=I |
| | Y25-2 X=BF₄ |
| | Y25-3 X=N(SO₂CF₃)₂ |
| 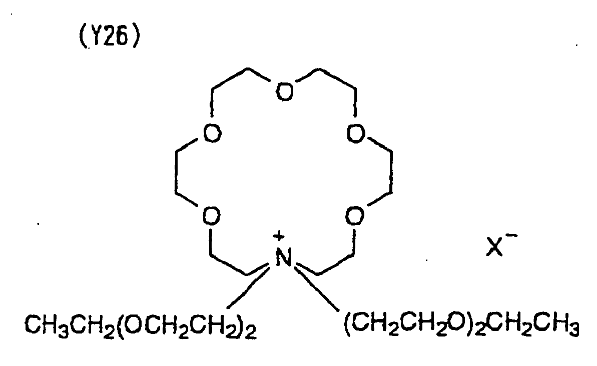 | Y26-1 X=I |
| | Y26-2 X=BF₄ |
| | Y26-3 X=N(SO)₂CF₃)₂ |
| 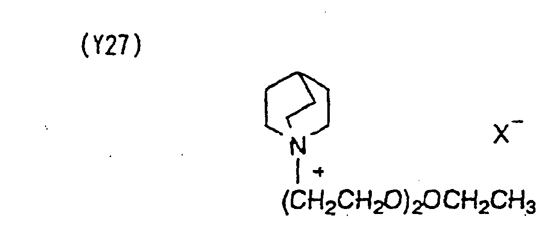 | Y27-1 X=I |
| | Y27-2 X=BF₄ |
| | Y27-3 X=N(SO₂CF₃)₂ |
| 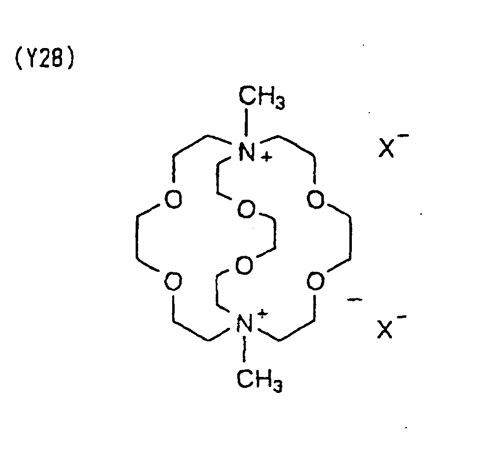 | Y28-1 X=I |
| | Y28-2 X=BF₄ |
| | Y28-3 X=N(SO₂CF₃)₂ |
| 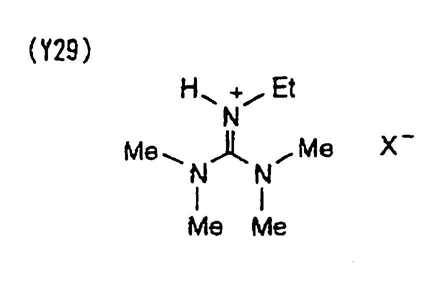 | Y29-1 X=I |
| | Y29-2 X=N(SO₂CF₃)₂ |
| | Y29-3 X=BF₄ |
| | Y29-4 X=PF₆ |
| 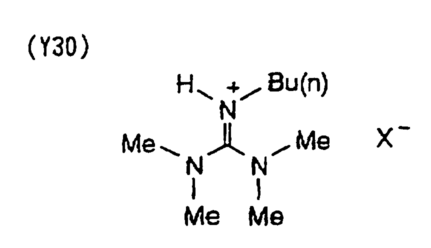 | Y30-1 X=I |
| | Y30-2 X=N(SO₂CF₃)₂ |
| | Y30-3 X=BF₄ |
| | Y30-4 X=CF₃SO₃ |
| 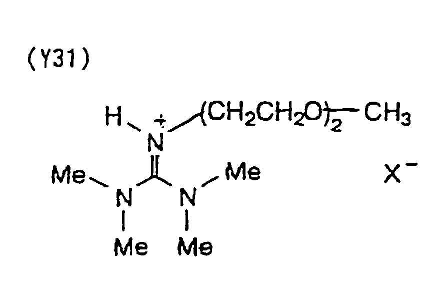 | Y31-1 X=I |
| | Y31-2 X=N(SO₂CF₃)₂ |
| | Y31-3 X=BF₄ |
| | |
| 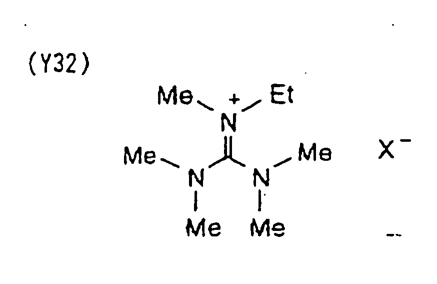 | Y32-1 X=I |
| | Y32-2 X=N(SO₂CF₃)₂ |
| | Y32-3 X=BF₄ |
| | |
| 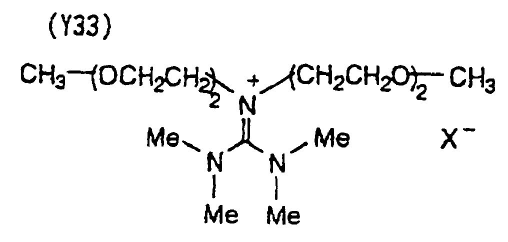 | Y33-1 X=I |
| | Y33-2 X=N(SO₂CF₃)₂ |
| | Y33-3 X=BF₄ |
| 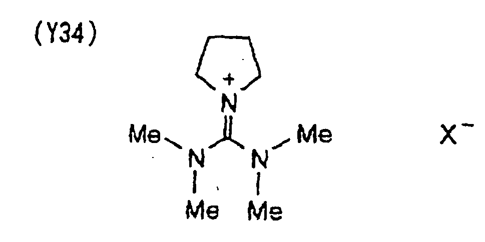 | Y34-1 X=I |
| | Y34-2 X=N(SO₂CF₃)₂ |
| | Y34-3 X=BF₄ |
| 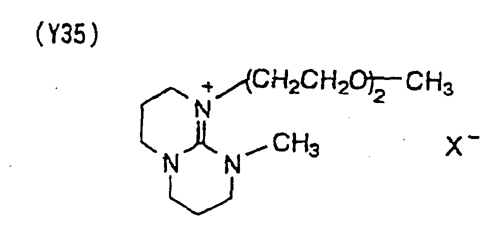 | Y35-1 X=I |
| | Y35-2 X=N(SO₂CF₃)₂ |
| | Y35-3 X=BF₄ |
| 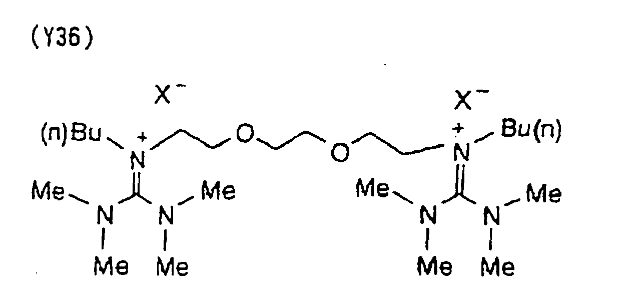 | |
| | Y36-1 X=I |
| | Y36-2 X=N(SO₂CF₃)₂ |
| | Y36-3 X=BF₄ |

While the molten salt can be used with or without the solvent hereinafter described, it is preferred that the molten salt be used without a solvent. When used with a solvent, the molten salt is preferably used in an amount of at least 50% by weight based on the total electrolyte composition, and 50% by weight or more, particularly 70% by weight or more, of the molten salt is preferably an iodine salt.

It is preferable to add iodine to the electrolyte composition. Iodine is preferably added in an amount of 0.1 to 20% by weight, particularly 0.5 to 5% by weight, based on the total electrolyte composition.

### (2) Electrolytic Solution

Where an electrolytic solution is used to form a charge transporting layer, it preferably comprises an electrolyte, a solvent, and additives. Preferred electrolytes include combinations of I₂ and iodides (for example, metal iodides, such as LiI, NaI, KI, CsI or CaI₂, and an iodine salt of quaternary ammonium compounds, such as a tetraalkylammonium iodide, pyridinium iodide and imidazolium iodide); combinations of Br₂ and bromides (for example, metal bromides, such as LiBr, NaBr, KBr, CsBr or CaBr₂, and a bromine salt of quaternary ammonium compounds, such as a tetraalkylammonium bromide or pyridinium bromide); metal complexes, such as a ferrocyananate-ferricyanate system or a ferrocene-ferricinium ion system; sulfur compounds, such as poly(sodium sulfite) and an alkylthiol-alkyl disulfide; viologen dyes; hydroquinone-quinone; and the like. Preferred of them are combinations of I₂ and an iodine salt of a quaternary ammonium compound, such as pyridinium iodide or imidazolium iodide. These electrolytes can be used either individually or as a mixture thereof.

A preferred electrolyte concentration is 0.1 to 15 M, particularly 0.2 to 10 M. Where iodine is added to the electrolyte, it is added preferably in a concentration of 0.01 to 0.5 M.

The solvent used to dissolve the electrolyte is preferably selected from those having a low viscosity to improve ion mobility or those having a high dielectric constant to improve an effective carrier concentration, thereby to develop excellent ionic conduction. Such solvents include carbonate compounds, such as ethylene carbonate and propylene carbonate; heterocyclic compounds, such as 3-methyl-2-oxazolidinone; ether compounds, such as dioxane and diethyl ether; acyclic ethers, such as ethylene glycol dialkyl ethers, propylene glycol dialkyl ethers, polyethylene glycol dialkyl ethers, and polypropylene glycol dialkyl ethers; alcohols, such as methanol, ethanol, ethylene glycol monoalkyl ethers, propylene glycol monoalkyl ethers, polyethylene glycol monoalkyl ethers, and polypropylene glycol monoalkyl ethers; polyhydric alcohols, such as ethylene glycol, propylene glycol, polyethylene glycol, polypropylene glycol, and glycerol; nitrile compounds, such as acetonitrile, glutaronitrile, methoxyacetonitrile, propionitrile, and benzonitrile; aprotic polar solvents, such as dimethyl sulfoxide and sulfolane; and water.

The electrolyte can contain a basic compound, such as t-butylpyridine, 2-picoline, and 2,6-lutidine, as disclosed in J. Am. Ceram. Soc., vol. 80, No. 12, pp. 3157-3171 (1997). A preferred concentration of the basic compound, if added, is 0.05 to 2 M.

### (3) Positive Hole-Transporting Material

A positive hole-transporting material, organic and/or inorganic, can be used in place of the electrolyte.

### (a) Organic Positive Hole-Transporting Material

Useful organic hole-transporting materials include aromatic amines, such as N,N'-diphenyl-N,N'-bis(4-methoxyphenyl)-(1,1'-biphenyl)-4,4'-diamine (see J. Hagen et al., Synthetic Metal, vol. 89, pp. 215-220 (1997)), 2,2',7,7'-tetrakis(N,N-di-p-methoxyphenylamine)-9,9'-spirobifluorene (see Nature, vol. 395, pp. 583-585 (Oct. 8, 1998) and WO97/10617), aromatic diamine compounds composed of tertiary aromatic amine units, 1,1-bis{4-(di-p-tolylamino)phenyl}cyclohexane, linked together (see JP-A-59-194393), aromatic amine compounds containing two or more tertiary amino groups and having two or more condensed aromatic rings each bonded to the nitrogen atom of the tertiary amino group, typically exemplified by 4,4'-bis[(N-1-naphthyl)-N-phenylamino]biphenyl (see JP-A-5-234681), aromatic triamines derived from triphenylbenzene and having a star-burst structure (see U.S. Patent 4,923,774 and JP-A-4-308688), aromatic diamines, such as N,N'-diphenyl-N,N'-bis(3-methylphenyl)-(1,1'-biphenyl)-4,4'-diamine (see U.S. Patent 4,764,625), α,α,α',α'-tetramethyl-α,α'-bis(4-di-p-tolylaminophenyl)-p-xylene (see JP-A-3-269084), p-phenylenediamine derivatives, triphenylamine derivatives which are sterically asymmetric as a whole molecule (see JP-A-4-129271), compounds having a plurality of aromatic diamino groups on a pyrenyl group (see JP-A-4-175395), aromatic diamines composed of aromatic tertiary amine units linked together via an ethylene group (see JP-A-4-264189), aromatic diamines having a styryl structure (see JP-A-4-290851), benzylphenyl compounds (see JP-A-4-364153), compounds composed of tertiary amines linked together via a fluorene group (see JP-A-5-25473), triamine compounds (see JP-A-5-239455), bisdipyridylaminobiphenyl compounds (see JP-A-5-320634), N,N,N-triphenylamine derivatives (see JP-A-6-1972), aromatic diamines having a phenoxazine structure (JP-A-7-138562), and diaminophenylphenanthridine derivatives (JP-A-7-252474).

Additionally, thiophene derivatives or oligomeric thiophene derivatives, such as α-octylthiophene, α,ω-dihexyl-α-octylthiophene (see Adv. Mater., vol. 9, No. 7, p. 557 (1997)), hexadodecyldodecithiophene (see Angew. Chem. Int. Ed. Engl., vol. 34, No. 3, pp. 303-307 (1995)), and 2,8-dihexylanthra[2,3-b:6,7-b']dithiophene (see JACS, vol. 120, No. 4, pp. 664-672 (1998)); and electrically conductive polymers, such as polypyrrole compounds (see K. Murakoshi et al., Chem. Lett., p. 471 (1997)) and polyacetylene and derivatives thereof, poly(p-phenylene) and derivatives thereof, poly(p-phenylenevinylene) and derivatives thereof, polythienylenevinylene and derivatives thereof, polythiophene and derivatives thereof, polyaniline and derivatives thereof, and polytoluidine and derivatives thereof (see Nalwa, Handbook of Organic Conductive Molecules and Polymers, vols. 1, 2, 3 and 4, Wiley).

As taught in Nature, vol. 395, pp. 583-585 (Oct. 8, 1998), a compound containing a cationic radical, such as tris(4-bromophenyl)aluminum hexachloroantimonate, can be added to the hole-transporting material so as to control the dopant level, or a salt such as Li[(CF₃SO₂)₂N] can be added to control the potential on the oxide semiconductor surface (i.e., compensation for a space charge layer).

### (b) Inorganic Positive Hole Transporting Material

p-Type inorganic compound semiconductors can be used as an inorganic positive hole transporting material. It is preferred for the p-type compound semiconductor to have a large band gap so as not to interfere with dye absorption. A preferred band gap is 2 eV or more, particularly 2.5 eV or more. In order to reduce the dye holes, it is necessary for the p-type compound semiconductor to have an ionization potential smaller than that of the dye-sensitized electrode. While a preferred range of the ionization potential of the p-type semiconductor used in the charge transporting layer varies depending on the sensitizing dye used, it is usually 4.5 to 5.5 eV, particularly 4.7 to 5.3 eV. The p-type inorganic compound semiconductor which can preferably be used in the invention includes compound semiconductors containing monovalent copper, such as CuI, CuSCN, CuInSe₂, Cu(In,Ga)Se₂, CuGaSe₂, Cu₂O, CuS, CuGaS₂, CuInS₂, and CuAlSe₂, with CuI and CuSCN being preferred. CuI is the most preferred. In addition to the copper-containing compounds, GaP, NiO, CoO, FeO, Bi₂O₃, MoO₂, Cr₂O₃, etc. are also useful as a p-type inorganic compound semiconductor.

The charge transporting layer comprising the p-type inorganic compound semiconductor preferably has a hole mobility of 10⁻⁴ to 10⁴ cm²/V·sec., particularly 10⁻³ to 10³ cm²/V·sec. The charge transporting layer of the invention preferably has an electrical conductivity of 10⁻⁸ to 10² S/cm, particularly 10⁻⁶ to 10 S/cm.

### (D) Counter Electrode

The counter electrode functions as a positive electrode of the photoelectric conversion device. Similarly to the electrically-conductive substrate hereinabove described, the counter electrode can have a single layer structure made of an electrically-conductive material or can comprise a base and an electrically-conductive layer. Electrically-conductive materials of choice for the counter electrode include metals (e.g., platinum, gold, silver, copper, aluminum, magnesium, rhodium, and indium), carbon, and electrically-conductive metal oxides (e.g., indium-tin complex oxide and Fluorine-doped tin oxide). Preferred among them are platinum, gold, silver, copper, aluminum, and magnesium. Suitable bases include glass and plastics, on which the electrically-conductive material is applied by coating or vacuum deposition. While not limiting, the counter electrode preferably has a thickness of 3 nm to 10 µm. In particular, a metallic counter electrode preferably has a thickness of 5 µm or smaller, particularly 5 nm to 3 µm. It is preferred for the counter electrode to have as low a surface resistivity as possible. A preferred surface resistivity is 80 Ω/square or less, particularly 20 Ω/square or less.

Since the photoelectric conversion device is irradiated with light from either one or both sides thereof, at least one of the electrically-conductive substrate (of the work electrode) and the counter electrode must be substantially transparent so that incident light can reach the photosensitive layer. From the standpoint of power generation efficiency, it is preferred that the electrically-conductive substrate be transparent so that light may enter through this side. In this case, it is a preferred embodiment that the counter electrode has light reflecting properties. A glass or plastic base having a metal or an electrically-conductive metal oxide deposited thereon or a thin metal film can be used as a reflecting counter electrode.

### (E) Other Layers

It is a preferred embodiment to previously provide a dense and thin semiconductor layer on the electrically-conductive substrate as an undercoat to prevent a short circuit between the counter electrode and the electrically-conductive substrate particularly where a positive hole transporting material is used in the charge transporting layer. The undercoat preferably comprises an oxide semiconductor, such as TiO₂, SnO₂, Fe₂O₃, WO₃, ZnO, and Nb₂O₅. TiO₂ is still preferred. The undercoat can be formed by, for example, spray pyrolysis as described in Electrochimi. Acta, vol. 40, pp. 643-652 (1995). A preferred thickness of the undercoat is 5 to 1000 nm, particularly 10 to 500 nm.

If necessary, additional functional layers, such as a protective layer and an antireflection layer, can be formed on the electrically-conductive substrate and/or the counter electrode. Where a plurality of additional layers having the respective functions are to be provided, while they can be formed either simultaneously or successively, simultaneous coating is preferred for productivity. Simultaneous coating is conveniently carried out by a slide hopper method or extrusion coating in view of productivity and uniformity of the film formed. Depending on the material, these functional layers may be provided by vacuum evaporation or press bonding.

### (F) Internal Structure of Photoelectric conversion device

As described above, the photoelectric conversion device can have a variety of internal structures in conformity with the end use. Conceivable forms are roughly divided into two types; structures which receive light from both sides and those which receive light from one side. Internal structures of photoelectric conversion devices that are suitably applied to the present invention are shown in Figs. 2 through 9.

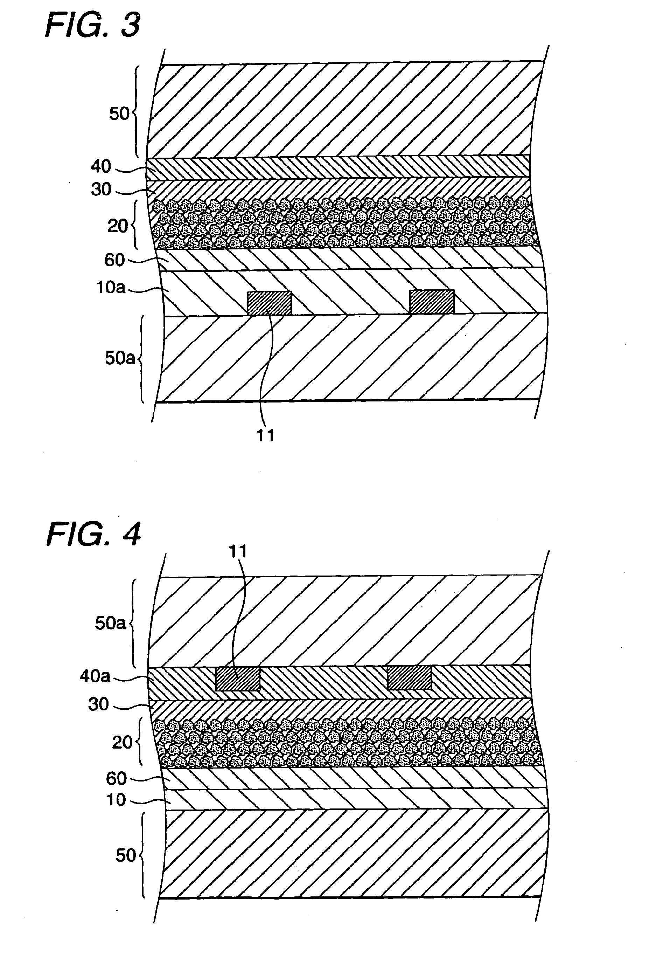

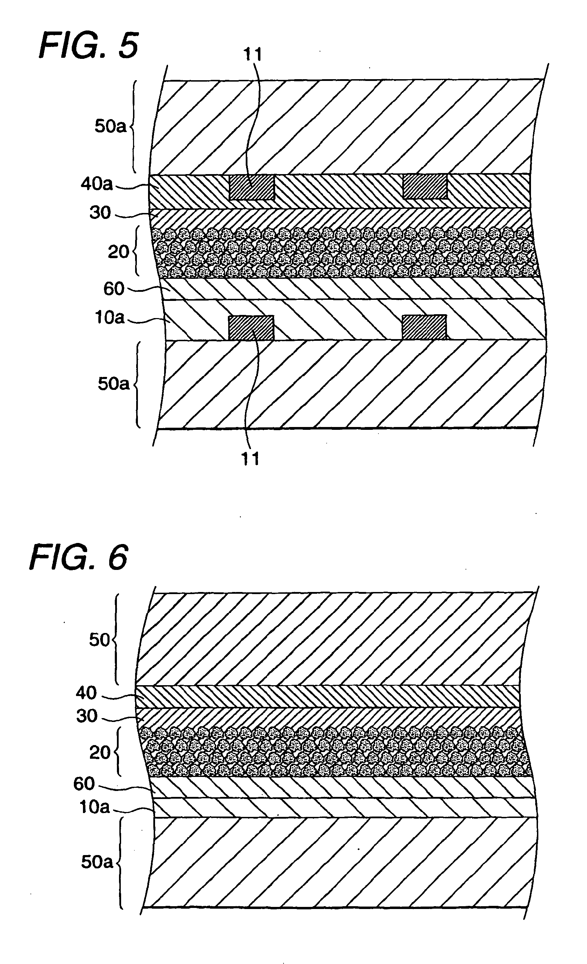

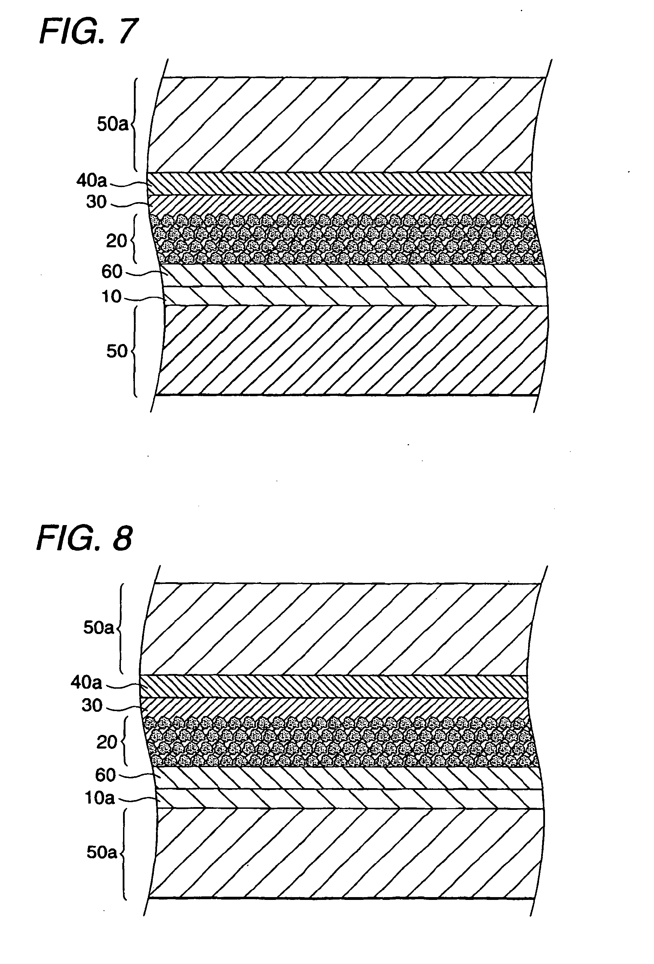

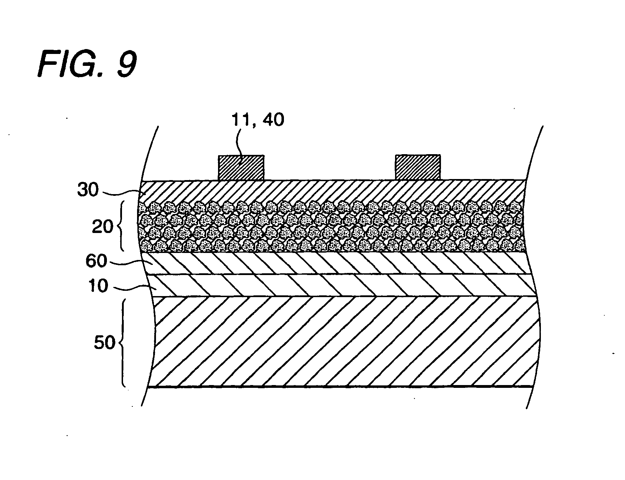

Fig. 2 is a structure made up of a transparent electrically-conductive layer 10a and a transparent counter electrode electrically-conductive layer 40a having interposed therebetween a photosensitive layer 20 and a charge transporting layer 30, which allows light to enter from its both sides. Fig. 3 is a structure having, in the order described, a transparent base 50a, a metal lead 11 which is provided in parts, a transparent electrically-conductive layer 10a, an undercoat 60, a photosensitive layer 20, a charge transporting layer 30, a counter electrode electrically-conductive layer 40, and a base 50, which allows light to enter from its electrically-conductive layer side. Fig. 4 shows a structure having, in the order described, a base 50, an electrically-conductive layer 10, an undercoat 60, a photosensitive layer 20, a charge transporting layer 30, a transparent counter electrode electrically-conductive layer 40a, and a transparent base 50a partially having thereon a metal lead 11 with the metal lead 11 inside, which allows light to enter from the counter electrode side. Fig. 5 is a structure having, in the order described, a transparent base 50a, a metal lead 11 which is provided in parts, a transparent electrically-conductive layer 10a, an undercoat 60, a photosensitive layer 20, a charge transporting layer 30, a transparent counter electrode electrically-conductive layer 40a, and another transparent base 50a having thereon a metal lead 11 in parts with the metal lead 11 inside, which allows light to enter from both sides thereof. Fig. 6 depicts a structure having, in the order described, a transparent base 50a, a transparent electrically-conductive layer 10a, an undercoat 60, a photosensitive layer 20, a charge transporting layer 30, a counter electrode electrically-conductive layer 40, and a base 50, which allows light to enter from its electrically-conductive layer side. Fig. 7 illustrates a structure having, in the order described, a base 50, an electrically-conductive layer 10, an undercoat 60, a photosensitive layer 20, a charge transporting layer 30, a transparent counter electrode electrically-conductive layer 40a, and a transparent base 50a, which allows light to enter from the counter electrode side. Fig. 8 shows a structure having, in the order described, a transparent base 50a, a transparent electrically-conductive layer 10a, an undercoat 60, a photosensitive layer 20, a charge transporting layer 30, a transparent counter electrode electrically-conductive layer 40a, and a transparent base 50a, which allows light to enter from its both sides. Fig. 9 is a structure having, in the order described, a base 50, an electrically-conductive layer 10, an undercoat 60, a photosensitive layer 20, a solid charge transporting layer 30, and a counter electrode electrically-conductive layer 40 or a metal lead 11 provided in parts, which allows light to enter from the counter electrode side.

### [II] Photocell

The photocell of the present invention is a practical application of the above-described photoelectric conversion device, in which the photoelectric conversion device is designed to work in an external circuit to which it is connected. A photocell preferably has its sides sealed with a polymer, an adhesive, etc. to prevent deterioration or volatilization of the inside substances. The external circuit connected to the electrically-conductive substrate and the counter electrode via the respective leads is well known. The solar cell to which the photoelectric conversion device of the invention is applied basically has the same internal structure as the above-described photoelectric conversion device. With reference to module structures of solar cells, known techniques are applied.

### EXAMPLE

The present invention will now be illustrated in greater detail with reference to Examples, but it should be understood that the invention is not limited thereto. Unless otherwise noted, all the percents are by weight.

### EXAMPLE 1

### 1) Preparation of transparent electrically-conductive substrate (photoanode)

A 1.9 mm thick alkali-free glass sheet was uniformly coated with Fluorine-doped tin dioxide by CVD to prepare a transparent electrically-conductive substrate having on one side thereof a 600 nm thick electrically-conductive tin dioxide film having a surface resistivity of about 15 Ω/square and a light transmission (500 nm) of 85%.

### 2) Preparation of titanium dioxide-containing coating composition

A titanium dioxide dispersion having a concentration of 11% was prepared from titanium tetraisopropoxide in accordance with the method reported in C.J. Barbe, et al, J. Am. Ceram. Soc., vol. 80, p. 3157 (1997), except that the autoclave temperature was set at 230°C. The average primary particle size of the resulting titanium dioxide particles was about 10 nm. To the dispersion was added polyethylene glycol (average molecular weight: 20,000, available from Wako Pure Chemical Ind., Ltd.) in an amount of 30% based on the titanium dioxide to prepare a viscous coating composition.

### 3) Preparation of particulate semiconductor layer

The coating composition was applied to the electrically-conductive layer side of the transparent electrically-conductive substrate prepared in (1) above with a doctor blade to a thickness of 100 µm, dried at 25°C for 60 minutes, and fired in an electric furnace at 500°C for 30 minutes to form a titanium dioxide layer. The coating weight and thickness of the titanium dioxide layer were 10 g/m² and 8 µm, respectively.

### 4) Preparation of dye solution

A ruthenium complex dye R-11 was dissolved in a dried mixture of acetonitrile and t-butanol (1:1) in a concentration of 3 x 10⁻⁴ mol/l, and a pasty organic sulfonic acid derivative S-11 (n=3) was dissolved therein in a concentration of 0.025 mol/l.

### 5) Dye adsorption

The TiO₂-coated glass substrate was immersed in the dye solution prepared in (4) above and allowed to stand at 40°C for 3 hours while stirring. The dyed glass substrate was washed with ethanol, and dried to prepare a dye-sensitized electrode. The amount of the dye adsorbed was about 1.2 x 10⁻³ mol/m². The light absorption wavelength of the electrode was about 800 nm at the longest.

A dye-sensitized electrode was prepared in the same manner as described above, except for replacing R-11 with R-10 (black dye) having an absorption at longer wavelengths. The light absorption wavelength of the resulting electrode was about 900 nm at the longest.

In order to compare the effect of the organic sulfonic acid derivatives, dye-sensitized electrodes were prepared in the same manner as described above, except for replacing S-11 (n=3) with the compounds shown in Table 1 below.

### 6) Preparation of photocell

The TiO₂ layer of the dye-sensitized electrode was scraped off, leaving a circle of 8 mm diameter (area: 0.5 cm²) as a light-receiving area. A platinum-deposited glass substrate was superposed on the electrode with a polyethylene film flame spacer of heat pressure bonding type (thickness: 20 µm) interposed therebetween. The two electrodes were pressure bonded while heating the spacer to 120°C, and the edges of the cell were sealed with an epoxy resin adhesive. A room temperature molten salt consisting of Y7-2, Y8-1, and iodine in a weight ratio of 15:35:1 was made to penetrate into the gap between the electrodes by making use of capillarity from a small hole that had been made at a corner of the counter electrode. All the steps of cell assembly and penetration with the electrolyte were carried out in dry air having a dew point of -60°C. The inside of the cell was evacuated by suction in vacuo for several hours to remove air, and the small hole was closed with low-melting glass.

There were thus obtained wet type photocells comprising dye-sensitized semiconductors having different combinations of a dye and an additive (sulfonic acid derivative) as shown in Table 1 to have different wavelength characteristics.

### 7) Measurement of photoelectric efficiency

The cell was irradiated with simulated sunlight having an intensity of 100 mW/cm² which was created by cutting light from a 500 W xenon lamp (produced by Ushio Inc.) through a correction filter (AM1.5 direct, available from Oriel). The generated electricity was recorded with a Keithley electrometer (Model SMU238). The open circuit voltage (Voc), short circuit current density (Jsc), and conversion efficiency (η) of the photocell as calculated from the quantity of generated electricity are shown in Table 1.

**TABLE 1**

| Cell No. | Sensitizing Dye | Additive | Jsc (mA/cm²) | Voc (V) | η (%) |
|---|---|---|---|---|---|
| R1^{*} | R-1 | none | 12.0 | 0.62 | 5.2 |
| R2^{*} | R-10 | none | 9.5 | 0.56 | 3.7 |
| 1 | R-1 | S-11 (n=3) | 12.1 | 0.67 | 6.1 |
| 2 | R-1 | S-11 (n=5) | 12.2 | 0.66 | 6.0 |
| 3 | R-1 | S-20 (n=3) | 12.0 | 0.66 | 5.9 |
| 4 | R-1 | S-21 (R=octyl) | 12.1 | 0.65 | 5.9 |
| 5* | R-1 | S-15 | 12.0 | 0.65 | 5.8 |
| 6* | R-1 | S-12 (n=10) | 11.9 | 0.64 | 5.7 |
| 7 | R-10 | S-11 (n=3) | 11.5 | 0.60 | 4.8 |
| 8 | R-10 | S-11 (n=5) | 11.3 | 0.60 | 4.7 |
| 9 | R-10 | S-20 (n=3) | 10.8 | 0.59 | 4.5 |
| 10 | R-10 | S-21 (R=octyl) | 10.5 | 0.59 | 4.3 |
| 11* | R-10 | S-15 | 10.7 | 0.60 | 4.5 |
| 12 | R-10 | S-12 (n=10) | 9.7 | 0.58 | 3.9 |

| | | | | | |
|---|---|---|---|---|---|
| Note: * Comparative samples | | | | | |

It is seen from the results in Table 1 that the solar cells produced according to the present invention exhibit excellent performance in providing a high energy conversion efficiency while maintaining a high level of output voltage (Voc).

The present invention provides dye-sensitized photoelectric conversion device and a photocell having a high output voltage and an improved energy conversion efficiency.

## Claims

1. Semiconductor particles having a dye adsorbed thereon in the presence of an anionic organic sulfonic acid derivative represented by the formula (II):
R₂-Ph-O-(CH₂CH₂O)ₙ-L₂-SO₃⁻M⁺ (II)
wherein R₂ represents a straight-chain or branched alkyl group; Ph represents a phenylene group; n represents an integer of from 0 to 50; L₂ represents a single bond, a substituted or unsubstituted alkylene group or a substituted or unsubstituted alkyleneoxy group; and M⁺ represents a cation,
wherein said semiconductor particles are at least one metal oxide selected from TiO₂, TiSrO₃, ZnO, WO₃, Nb₂O₅, and SnO₂.

2. The semiconductor particles of claim 1, wherein M⁺ represents an alkali metal ion.

3. The semiconductor particles of claim 1 or 2, wherein said dye is at least one dye selected from organic metal complex dyes, phthalocyanine dyes, porphyrin dyes, and polymethine dyes.

4. The semiconductor particles of any one of claims 1 to 3, wherein said dye is an organic metal complex dye.

5. A photoelectric conversion device comprising an electrode having the semiconductor particles of any one of claims 1 to 4, a charge transporting layer, and a counter electrode.

6. The photoelectric conversion device of claim 5, wherein said charge transporting layer comprises a molten salt electrolyte.

7. The photoelectric conversion device of claim 5 or 6, wherein said charge transporting layer comprises a room temperature molten salt which mainly comprises an imidazolium salt and contains no volatile components.

8. A method of preparing the semiconductor particles of claim 1, comprising the step of adsorbing said dye on semiconductor particles selected from TiO₂, SrTiO₃, ZnO, WO₃, Nb₂O₅ and SnO₂ by using a solution containing said anionic organic sulfonic acid derivative represented by formula (II)and said dye.

9. A method of preparing the semiconductor particles of claim 1, comprising the step of adsorbing said dye on semiconductor particles selected from TiO₂, SrTiO₃, ZnO, WO₃, Nb₂O₅ and SnO₂ by first allowing said anionic organic sulfonic acid derivative represented by formula (II) to be adsorbed by said semiconductor particles and then allowing said dye to be adsorbed thereon.

## Patentansprüche

1. Halbleiterteilchen, an denen ein Farbstoff in Gegenwart eines anionischen organischen Sulfonsäurederivats der Formel (II) adsorbiert wurde:
R₂-Ph-O-(CH₂CH₂O)ₙ-L₂-SO₃⁻M⁺ (II)
worin R₂ eine geradkettige oder verzweigte Alkylgruppe ist; Ph ist eine Phenylengruppe; n ist eine ganze Zahl von 0 bis 50; L₂ ist eine Einfachbindung, eine substituierte oder unsubstituierte Alkylengruppe oder eine substituierte oder unsubstituierte Alkylenoxygruppe; und M⁺ ist ein Kation,
wobei die Halbleiterteilchen mindestens ein Metalloxid sind, ausgewählt aus TiO₂, TiSrO₃, ZnO, WO₃, Nb₂O₅ und SnO₂.

2. Halbleiterteilchen nach Anspruch 1, wobei M⁺ ein Alkalimetallion ist.

3. Halbleiterteilchen nach Anspruch 1 oder 2, wobei der Farbstoff mindestens ein Farbstoff ist, ausgewählt aus organischen Metallkomplexfarbstoffen, Phthalocyaninfarbstoffen, Porphyrinfarbstoffen und Polymethinfarbstoffen.

4. Halbleiterteilchen nach einem der Ansprüche 1 bis 3, wobei der Farbstoff ein organischer Metallkomplexfarbstoff ist.

5. Photoelektrische Umwandlungsvorrichtung, umfassend eine Elektrode mit den Halbleiterteilchen nach einem der Ansprüche 1 bis 4, eine Ladungen transportierende Schicht und eine Gegenelektrode.

6. Photoelektrische Umwandlungsvorrichtung nach Anspruch 5, wobei die Ladungen transportierende Schicht ein geschmolzenes Salz als Elektrolyten umfasst.

7. Photoelektrische Umwandlungsvorrichtung nach Anspruch 5 oder 6, wobei die Ladungen transportierende Schicht ein Salz umfasst, das bei Raumtemperatur geschmolzen ist und das im wesentlichen ein Imidazoliumsalz umfasst und keine flüchtigen Verbindungen enthält.

8. Verfahren zum Herstellen der Halbleiterteilchen nach Anspruch 1, umfassend das Adsorbieren des Farbstoffes an den Halbleiterteilchen, ausgewählt aus TiO₂, SrTiO₃, ZnO, WO₃, Nb₂0₅ und SnO₂, wobei eine Lösung verwendet wird, die das anionische organische Sulfonsäurederivat der Formel (II) und den Farbstoff enthält.

9. Verfahren zum Herstellen der Halbleiterteilchen nach Anspruch 1, umfassend das Adsorbieren des Farbstoffes an den Halbleiterteilchen, ausgewählt aus TiO₂, SrTiO₃, ZnO, WO₃, Nb₂O₅ und SnO₂, wobei zuerst das anionische organische Sulfonsäurederivat der Formel (II) an den Halbleiterteilchen adsorbiert wird und dann der Farbstoff an den Halbleiterteilchen adsorbiert wird.

## Revendications

1. Particules de semiconducteur présentant un colorant adsorbé sur leur dessus en présence d'un dérivé d'acide sulfonique organique anionique représenté par la formule (II) :
R₂-Ph-O-(CH₂CH₂O)ₙ-L₂-SO₃⁻M⁺ (II)
dans laquelle R₂ représente un groupe alkyle linéaire ou ramifié ; Ph représente un groupe phénylène ; n représente un nombre entier de 0 à 50 ; L₂ représente une liaison simple, un groupe alkylène substitué ou non substitué ou un groupe alkylèneoxy substitué ou non substitué ; et M⁺ représente un cation,
dans lesquelles lesdites particules de semiconducteur sont au moins un oxyde de métal choisi parmi -TiO₂, TSrO₃, ZnO, WO₃, Nb₂O₅ et SnO₂.

2. Particules de semiconducteur selon la revendication 1, dans lesquelles M⁺ représente un ion de métal alcalin.

3. Particules de semiconducteur selon la revendication 1 ou 2,
dans lesquelles ledit colorant est au moins un colorant choisi parmi des colorants de complexes de métaux organiques, des colorants de phtalocyanine, des colorants de porphyrine et des colorants de polyméthine.

4. Particules de semiconducteur selon l'une quelconque des revendications 1 à 3, dans lesquelles ledit colorant est un colorant de complexe de métal organique.

5. Dispositif de conversion photoélectrique comprenant une électrode présentant les particules de semiconducteur selon l'une quelconque des revendications 1 à 4, une couche de transport de charge et une contre-électrode.

6. Dispositif de conversion photoélectrique selon la revendication 5, dans lequel ladite couche de transport de charge comprend un électrolyte de sel fondu.

7. Dispositif de conversion photoélectrique selon la revendication 5 ou 6, dans lequel ladite couche de transport de charge comprend un sel fondu à température amblante qui comprend principalement un sel d'imidazolium et ne contient pas de constituant volatil.

8. Procédé de préparation des particules de semiconducteur selon la revendication 1 comprenant l'étape d'adsorption dudit colorant sur des particules de semiconducteur choisies parmi TiO₂, SrTiO₃, ZnO, WO₃, Nb₂O₅ et SnO₂ en utilisant une solution contenant ledit dérivé d'acide sulfonique organique, anionique représenté par la formule (II) et ledit colorant.

9. Procédé de préparation des particules de semiconducteur selon la revendication 1 comprenant l'étape d'adsorption dudit colorant sur des particules de semiconducteur choisies parmi TiO₂, SrTiO₃, ZnO, WO₃, Nb₂O₅ et SnO₂ en laissant dans un premier temps ledit dérivé d'acide sulfonique organique anionique représenté par la formule (II) être adsorbé par lesdites particules de semiconducteur et en laissant ensuite ledit colorant être adsorbé sur leur dessus.
